# EUROPEAN PATENT APPLICATION

(11) **EP 4 138 143 A1**
(43) Date of publication of application: **22.02.2023**
(21) Application number: 22182767.8
(22) Date of filing: 04.07.2022
(51) Int. Cl.: H01L 29/10, H01L 29/423, H01L 29/78

(54) **LEAKAGE INSENSITIVE TRANSISTOR CIRCUITS**

(30) Priority: 18.08.2021 US 202117405953
(71) Applicant: INTEL Corporation, Santa Clara, CA 95054 (US)
(72) Inventor: Nikonov, Dmitri Evgenievich, Beaverton, 97007 (US); Li, Hai, Portland, 97229 (US); Young, Ian Alexander, Olympia, 98512 (US)
(74) Representative: Goddar, Heinz J.

(57) **Abstract**

A leakage insensitive transistor includes a substrate, a source region, a drain region, a channel region between the source region and drain region, a gate dielectric on the channel region, first and second electrodes on the gate dielectric, and third and fourth electrodes on the substrate. The leakage insensitive transistor may be operated by applying a first logic signal to the first electrode, floating the second electrode of the FET, applying a second logic signal opposite the first logic signal to the third electrode, and floating the fourth electrode. A logic circuit may include multiple leakage insensitive transistors.

## Description

### BACKGROUND

Complementary metal-oxide-semiconductor (CMOS) field-effect transistor (FET) logic was a significant improvement step in lowering both active and standby power compared to NMOS or to bipolar transistor logic. It is based on the feature of CMOS logic that, in a steady state, the power consumption is determined by a relatively low leakage current in a MOSFET. However, as CMOS is scaled smaller and smaller according to Moore's law, the CMOS logic architecture may begin to show appreciable values of power dissipation. For instance, power dissipation may occur via source-to-drain leakage currents, e.g., through short-circuit current (sometimes also referred to as rush-through current) for the case of active power and by the leakage current for the case of passive power. The amount of power that is dissipated through these leakage currents may grow exponentially when the supply voltage is not changed, and these leakage problems stand in the way of lowering the supply voltage to accordingly lower device power consumption.

### BRIEF DESCRIPTION OF THE DRAWINGS

FIGS. 1A-1B illustrate an example leakage insensitive transistor in accordance with embodiments of the present disclosure.
FIGS. 2-3 illustrate an example planar n-channel field effect transistor (nFET) in accordance with embodiments of the present disclosure.
FIGS. 4-5 illustrate an example planar p-channel field effect transistor (pFET) in accordance with embodiments of the present disclosure.
FIGS. 6A-6B illustrate an example six-electrode FinFET in accordance with embodiments of the present disclosure
FIG. 7 illustrates an example control circuit design for a leakage insensitive transistor in accordance with embodiments of the present disclosure.
FIG. 8 illustrates an example inverter circuit implemented by six-electrode transistors in accordance with embodiments of the present disclosure.
FIG. 9 illustrates an example two-cascaded inverter circuit implemented by six-electrode transistors in accordance with embodiments of the present disclosure.
FIG. 10 illustrates an example NOR logic gate implemented by six-electrode transistors in accordance with embodiments of the present disclosure.
FIG. 11 illustrates an example NAND logic gate implemented by six-electrode transistors in accordance with embodiments of the present disclosure.
FIG. 12 illustrates an example hybrid logic circuit design that includes a 4-wire input logic circuit and converter circuits to convert classical/binary 1-wire input signals to 4-wire input signals (and vice versa) that may be utilized by the 4-wire input logic circuit.
FIG. 13 illustrates an example 4-wire to 1-wire logic signal converter circuit in accordance with embodiments of the present disclosure.
FIG. 14 is a top view of a wafer and dies that may be included in a microelectronic assembly, in accordance with any of the embodiments disclosed herein.
FIG. 15 is a cross-sectional side view of an integrated circuit device that may be included in a microelectronic assembly, in accordance with any of the embodiments disclosed herein.
FIGS. 16-16D are perspective views of example planar, FinFET, gate-all-around, and stacked gate-all-around transistors.
FIG. 17 is a cross-sectional side view of an integrated circuit device assembly that may include a microelectronic assembly, in accordance with any of the embodiments disclosed herein.
FIG. 18 is a block diagram of an example electrical device that may include a microelectronic assembly, in accordance with any of the embodiments disclosed herein.

### DETAILED DESCRIPTION

Traditional three- or four-electrode CMOS transistor designs may present issues with leakage current across the channel, especially as transistor designs are scaled down in size. Aspects of the present disclosure, however, may highly reduce or eliminate the conductive path from the supply electrode to the ground electrode along the channels of transistors. To accomplish this, embodiments of the present disclosure may include transistors with four control electrodes (e.g., two gate electrodes and two body electrodes), which allow the conductive path for leakage current to terminate. The transistors, just like traditional CMOS transistors may be implemented either as n-channel or p-channel designs depending on the polarity of the inverted channel.

Although transistor designs with 4 control electrodes in accordance with the present disclosure may be larger than traditional CMOS transistors with one control electrodes and may need additional wires to route the signals to the additional control electrodes, such designs may greatly lower the power dissipation, which in many instances may be worth the design trade off. For example, such a trade-off may be quite acceptable for circuits sensitive to standby power, including static random-access memory (SRAM). In addition, the four wires needed for control electrodes are in parallel and thus may not increase the routing complexity.

It will be understood that in the examples shown and described further below, the figures may not be drawn to scale and may not include all possible layers and/or circuit components. In addition, it will be understood that although certain figures illustrate transistor designs with source/drain regions, electrodes, etc. having orthogonal (e.g., perpendicular) boundaries, embodiments herein may implement such boundaries in a substantially orthogonal manner (e.g., within +/- 5 or 10 degrees of orthogonality) due to fabrication methods used to create such devices or for other reasons.

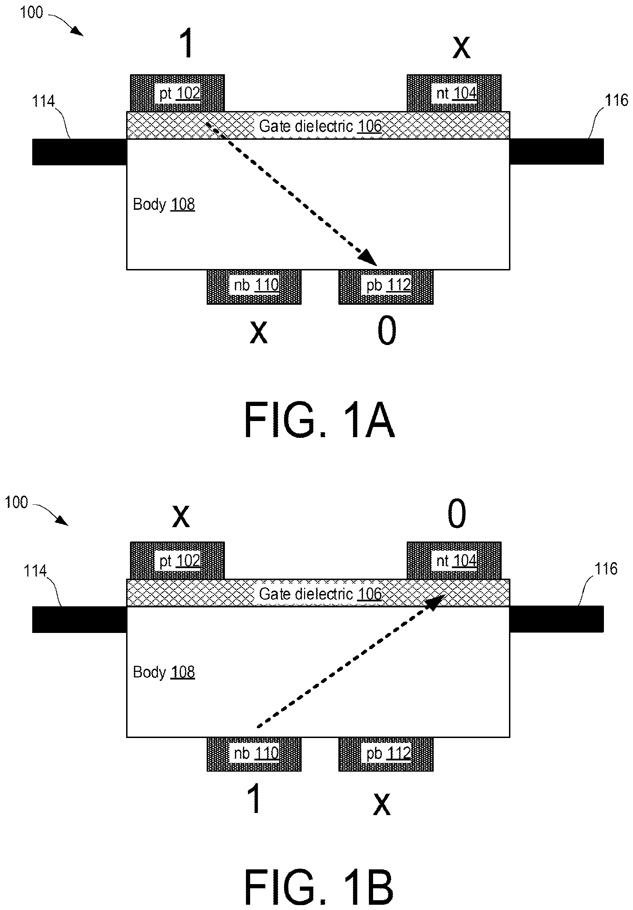

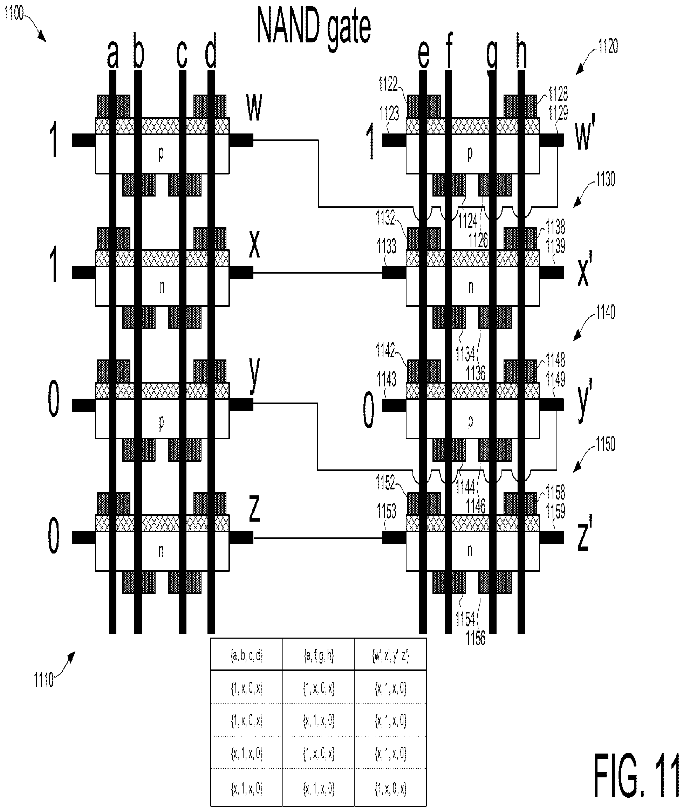

FIGS. 1A-1B illustrate an example leakage insensitive transistor 100 in accordance with embodiments of the present disclosure. The example transistor 100 includes six (6) electrodes as compared with the traditional three or four electrode MOSFET design. The example six electrode transistor 100 includes a first gate electrode 102 (pt), a second gate electrode 104 (nt), first body electrode 110 (nb), second body electrode 112 (pb), and source/drain electrodes 114, 116. The first and second gate electrodes 102, 104 are on a gate dielectric 106, which is in turn on a substrate body 108. The gate dielectric 106 may be composed of or include any suitable dielectric material for use as a gate dielectric in a MOSFET transistor, such as, for example, silicon oxide, silicon dioxide, silicon carbide, and/or a high-k dielectric material, or a high-k dielectric material as described further below with respect to FIG. 11. Likewise, the substrate body 108 may be composed of or include any suitable semiconductor material for use as a MOSFET substrate body, such as, for example, a crystalline substrate formed using a bulk silicon, a silicon-on-insulator (SOI) substructure, or another substrate material as described further below with respect to FIG. 11.

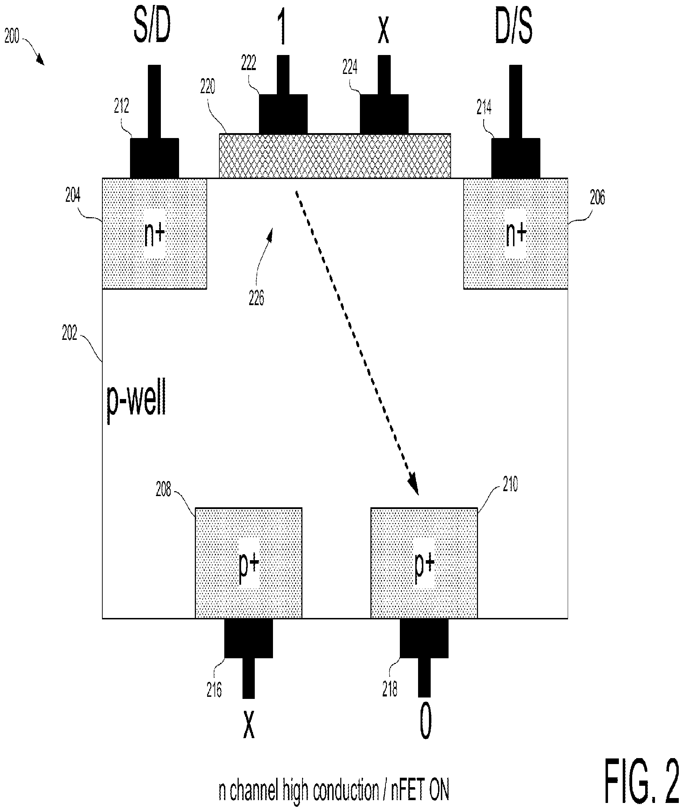

Although specific source/drain regions of the transistor 100 are not illustrated in the examples shown, it will be understood that embodiments of the present disclosure will include such regions (e.g., as shown in FIGS. 2-5) in addition to the aspects shown in FIGS 1A-1B. Further, the polarity of the transistor 100 is purposely ambiguous in the examples shown in FIGS. 1A-1B; however, it will be understood that the same architecture shown will apply to either p-channel or n-channel devices (e.g., as shown in FIGS. 2-5).

Two possible biasing states of the transistor 100 are shown in FIGS. 1A-1B. In the examples shown in FIGS. 1A-1B (as well as in other figures or description below), a "1" designates a logic 1 (e.g., a high voltage, supply voltage, etc.) applied to the relevant electrode, a "0" designates a logic 0 (e.g., a low voltage, ground, etc.) applied to the relevant electrode, and "x" designates a floating input/signal applied to the relevant electrode. In the first state shown in FIG. 1A, the first gate electrode 102 (pt) is at logic 1, the second gate electrode 104 (nt) is floating, the first body electrode 110 (nb) is floating, and the second body electrode 112 (pb) is at logic 0. This first state would lead to a conducting nMOS device and a shut-off pMOS device. In the second state shown in FIG. 1B, the first gate electrode 102 (pt) is floating, the second gate electrode 104 (nt) is at logic 0, the first body electrode 110 (nb) is at logic 1, and the second body electrode 112 (pb) is floating. This second state would lead to a conducting pMOS device and shut-off nMOS device.

In the example transistor 100, the short-circuit current described above may be greatly reduced or entirely eliminated as compared with a traditional CMOS transistor design. Moreover, the standby power dissipation of the transistor 100 may be suppressed by orders of magnitude when compared with the traditional CMOS transistor design. Further, with the transistor 100, one may no longer need to be concerned with the off-current, the subthreshold slope, as it may be limited by 60mV.decade (the so called 'Boltzmann tyranny'). In fact, the threshold voltage in the transistor 100 can be lowered to almost zero, which may permit lowering supply voltage, e.g., from 0.6V to 0.3V. Lowering the supply voltage could lead to a corresponding ~4x decrease in the switching energy of circuits that incorporate transistor similar to transistor 100. All the above benefits may be achieved without changes to the materials used or the process technologies used in creating traditional CMOS transistors.

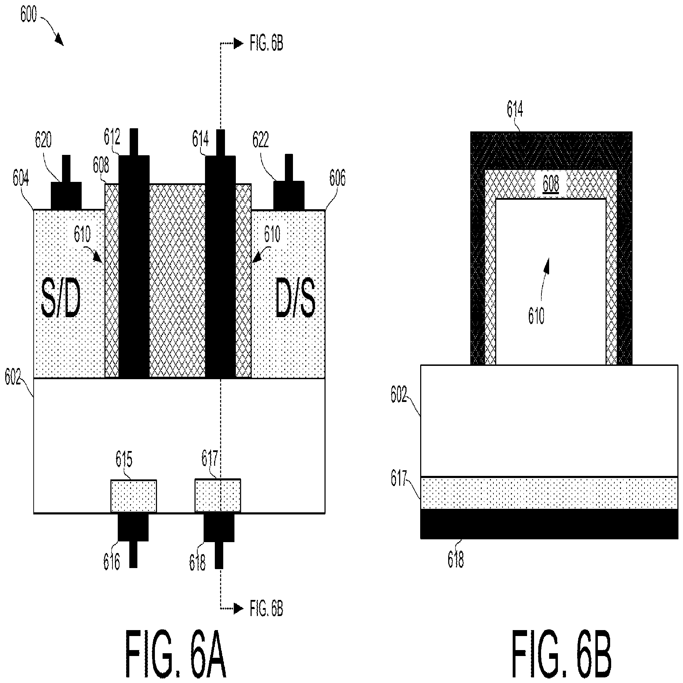

While the examples shown in FIGS. 1A-1B resemble a planar transistor, it will be understood that aspects of the present disclosure may be applied to both planar and non-planar transistor devices. For example, in some embodiments, planar transistor may implement a six-electrode design as shown in FIGS. 2-5. As another example, FinFET transistors may implement a six-electrode design as shown in FIGS. 6A-6B.

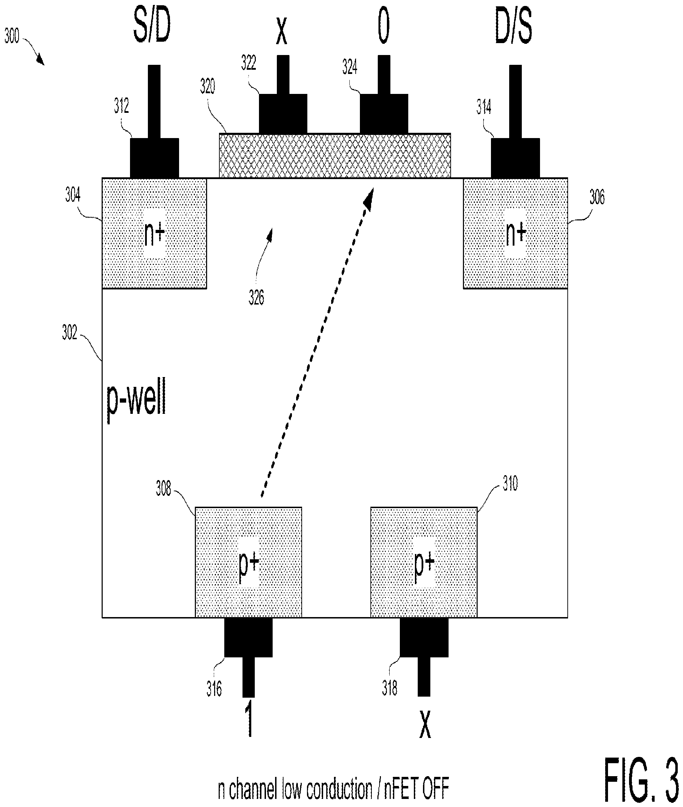

FIGS. 2-3 illustrate an example planar n-channel field effect transistor (nFET) in accordance with embodiments of the present disclosure. The example nFETs 200, 300 of FIGS. 2, 3, respectively, each include a p-well body region 202 with n-doped source/drain regions 204 near a first surface (top in FIGS. 2-3) of the nFET 200, and p-doped body regions 208, 210 near a second surface (bottom in FIGS. 2-3) of the nFET 200. In the example shown, the p-doped body regions 208, 210 are on an opposite side of the body region 202 from the n-doped source/drain regions 204, 206. However, the respective regions may be disposed in other locations of the body region 202 in other embodiments. The n-doped region 204 has an electrode 212 on an outer surface thereof (i.e., on the top surface of the nFET in FIGS. 2-3), the n-doped region 206 has an electrode 214 on an outer surface thereof (i.e., on the top surface of the nFET in FIGS. 2-3), the p-doped region 208 has an electrode 216 on an outer surface thereof (i.e., on the bottom surface of the nFET in FIGS. 2-3), and the p-doped region 210 has an electrode 218 on an outer surface thereof (i.e., on the bottom surface of the nFET in FIGS. 2-3). The example nFETs 200, 300 of FIGS. 2, 3, respectively, also each include a gate dielectric layer 220 on the same outer surface of the nFET proximate to which the source/drain regions 204, 206 (i.e., on the top surface of the nFET in FIGS. 2-3). The gate dielectric layer 220 is formed on the area of the outer surface above the channel region 226 between the source/drain regions 204, 206. The example nFETs 200, 300 of FIGS. 2, 3, respectively, also each include two electrodes 222, 224 on the gate dielectric layer 220.

Referring to FIG. 2, the example nFET 200 has a logic 1 voltage applied to the electrode 222 on the gate dielectric layer 220 while the electrode 224 on the gate dielectric layer 220 is floating (i.e., has no voltage applied thereto). In addition, example nFET 200 has a logic 0 voltage applied to the electrode 218 on the p-doped body region 210 while the electrode 216 on the p-doped body region 208 is floating (i.e., has no voltage applied thereto). The set of voltages applied to the electrodes 222, 224, 216, 218 may be referred to herein as input voltages or control voltages (or sets thereof). The input/control voltage configuration shown in FIG. 2 will result in the attraction of electrons to the channel region 226, causing a high conduction condition in the nFET 200, which may be referred to as the nFET being in the "ON" or "conducting" state.

Referring to FIG. 3, the example nFET 300 has a logic 0 voltage applied to the electrode 324 on the gate dielectric layer 320 while the electrode 322 on the gate dielectric layer 320 is floating (i.e., has no voltage applied thereto). In addition, example nFET 300 has a logic 1 voltage applied to the electrode 316 on the p-doped body region 308 while the electrode 318 on the p-doped body region 310 is floating (i.e., has no voltage applied thereto). The set of voltages applied to the electrodes 322, 324, 316, 318 may be referred to herein as input voltages or control voltages (or sets thereof). The input/control voltage configuration shown in FIG. 3 will result in the attraction of holes to the channel region 326, causing a low conduction condition in the nFET 300, which may be referred to as the nFET being in the "OFF" or "non-conducting" state.

In traditional CMOS transistor designs, leakage current may still occur in the channel in the OFF/non-conducting as described above. However, with the application of the logic 1 voltage to the electrode 316 and logic 0 voltage applied to the electrode 324 as shown in FIG. 3, leakage current in the channel region 326 may be greatly reduced or eliminated.

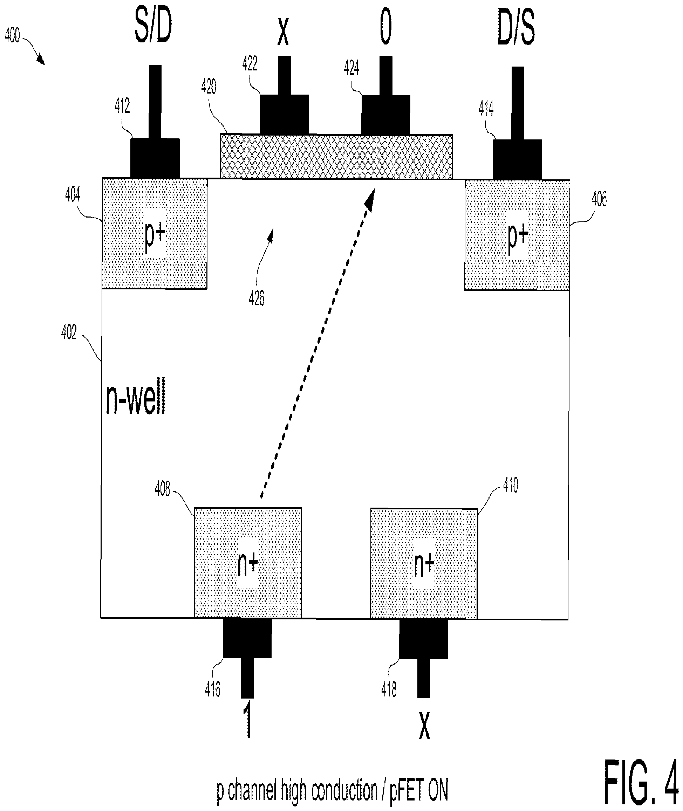

FIGS. 4-5 illustrate an example planar p-channel field effect transistor (pFET) in accordance with embodiments of the present disclosure.

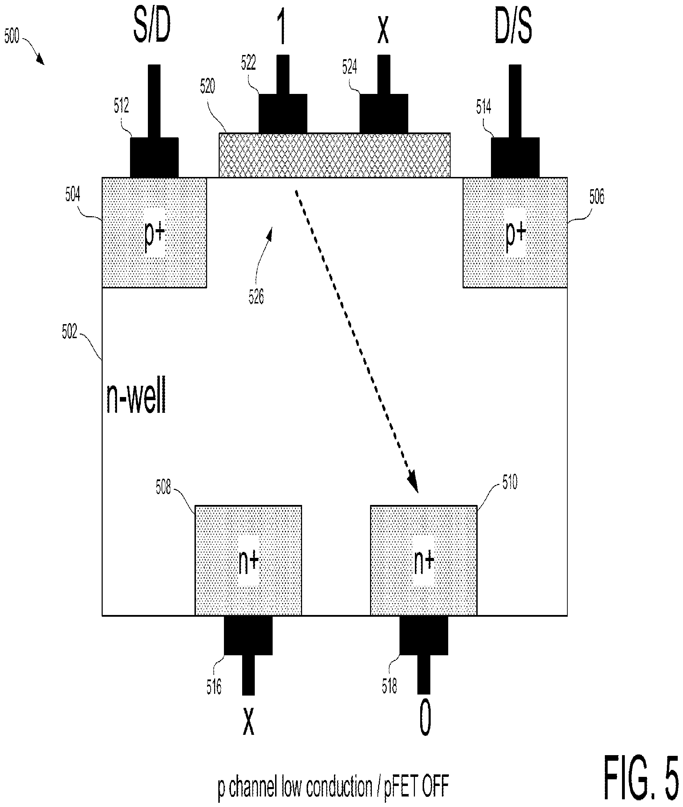

The example pFETs 400, 500 of FIGS. 4, 5, respectively, each include a n-well body region 402 with n-doped source/drain regions 404 near a first surface (top in FIGS. 4-5) of the pFET 400, and n-doped body regions 408, 410 near a second surface (bottom in FIGS. 4-5) of the pFET 400. In the example shown, the n-doped body regions 408, 410 are on an opposite side of the body region 402 from the p-doped source/drain regions 404, 406. However, the respective regions may be disposed in other locations of the body region 402 in other embodiments. The p-doped region 404 has an electrode 412 on an outer surface thereof (i.e., on the top surface of the pFET in FIGS. 4-5), the p-doped region 406 has an electrode 414 on an outer surface thereof (i.e., on the top surface of the pFET in FIGS. 4-5), the n-doped region 408 has an electrode 416 on an outer surface thereof (i.e., on the bottom surface of the pFET in FIGS. 4-5), and the n-doped region 410 has an electrode 418 on an outer surface thereof (i.e., on the bottom surface of the pFET in FIGS. 4-5). The example pFETs 400, 500 of FIGS. 4, 5, respectively, also each include a gate dielectric layer 420 on the same outer surface of the pFET proximate to which the source/drain regions 404, 406 (i.e., on the top surface of the pFET in FIGS. 4-5). The gate dielectric layer 420 is formed on the area of the outer surface above the channel region 426 between the source/drain regions 404, 406. The example pFETs 400, 500 of FIGS. 4, 5, respectively, also each include two electrodes 422, 424 on the gate dielectric layer 420.

Referring to FIG. 4, the example pFET 400 has a logic 0 voltage applied to the electrode 424 on the gate dielectric layer 420 while the electrode 422 on the gate dielectric layer 420 is floating (i.e., has no voltage applied thereto). In addition, the example pFET 400 has a logic 1 voltage applied to the electrode 416 on the n-doped body region 408 while the electrode 418 on the n-doped body region 410 is floating (i.e., has no voltage applied thereto). The set of voltages applied to the electrodes 422, 424, 416, 418 may be referred to herein as input voltages or control voltages (or sets thereof). The input/control voltage configuration shown in FIG. 4 will result in the attraction of holes to the channel region 426, causing a high conduction condition in the pFET 400, which may be referred to as the pFET being in the "ON" or "conducting" state.

Referring to FIG. 5, the example pFET 500 has a logic 1 voltage applied to the electrode 522 on the gate dielectric layer 520 while the electrode 524 on the gate dielectric layer 520 is floating (i.e., has no voltage applied thereto). In addition, example pFET 500 has a logic 0 voltage applied to the electrode 518 on the n-doped body region 510 while the electrode 516 on the n-doped body region 508 is floating (i.e., has no voltage applied thereto). The set of voltages applied to the electrodes 522, 524, 516, 518 may be referred to herein as input voltages or control voltages (or sets thereof). The input/control voltage configuration shown in FIG. 5 will result in the attraction of electrons to the channel 326, causing a low conduction condition in the pFET 500, which may be referred to as the pFET being in the "OFF" or "non-conducting" state.

In traditional CMOS transistor designs, leakage current may still occur in the channel in the OFF/non-conducting as described above. However, with the application of the logic 1 voltage to the electrode 522 and logic 0 voltage applied to the electrode 518 as shown in FIG. 5, leakage current in the channel region 526 may be greatly reduced or eliminated.

Although the example gate electrodes are shown in FIGS. 2-5 as being on particular locations of the gate dielectric layers, in some embodiments, the location, size, shape, etc. of the gate electrodes may be different than shown. In addition, in some embodiments, the location, size, shape, etc. of the body electrodes may be different than shown. Further, while the examples shown in FIGS. 2-5 are planar transistor devices, it will be understood that aspects of the present disclosure may be applied to non-planar transistor devices such as, for example, FinFET transistors (including double-gate transistors or tri-gate transistors).

FIGS. 6A-6B illustrate an example six-electrode FinFET 600 in accordance with embodiments of the present disclosure. In particular, FIG. 6A shows a side view of the example FinFET 600 and FIG. 6B shows a cross-section view of the example FinFET 600. The example FinFET 600 includes a substrate body 602 with raised source/drain regions 604, 606 that extend upwards from the substrate body 602 similar to "fins." The source/drain regions 604, 606 may be doped regions (either n-doped or p-doped, depending on the implementation of the FinFET 600). The substrate body 602 also includes doped body regions 615, 617, which may be doped in an opposite polarity than the source/drain regions 604, 606 (e.g., n-doped body regions 615, 617 where source/drain regions are p-doped). The FinFET 600 also includes a gate dielectric layer 608 that surrounds a channel region 610 between the source/drain regions 604, 606. In the example shown, the gate dielectric layer 608 surrounds the channel region 610 on three sides. The example FinFET 600 two gate electrodes 612, 614 on the gate dielectric layer 608, two body electrodes 616, 618 on the substrate body 602, and two source/drain electrodes 620, 622 on the source/drain regions 604, 606, respectively. In some instances, the gate dielectric layer 608 may be formed in a different manner than shown. For example, the gate dielectric layer may be in two separate dielectric layers beneath the gate electrodes 612, 614. For instance, in some embodiments, etching during the fabrication process of the FinFET 600 may cause a portion or the entirety of the gate dielectric layer 608 between the gate electrodes 612, 614 to be etched away.

The various components of the example FinFET 600 may be implemented in a similar manner to, or the same as, the FETs shown in FIGS. 1-5 and described above. For example, the materials used for the respective regions of the FETs may be similar or the same. Although the example gate electrodes 612, 614 are shown in FIGS. 6A-6B as being on a particular location of the gate dielectric layer 608, in some embodiments, the location, size, shape, etc. of the gate electrodes 612, 614 may be different than shown. In addition, in some embodiments, the location, size, shape, etc. of the body electrodes 616, 618 may be different than shown.

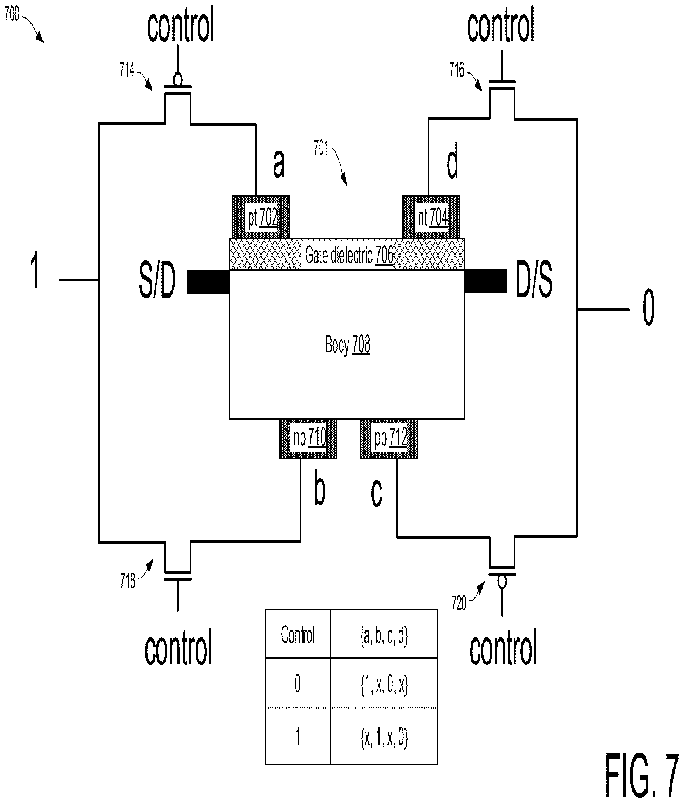

FIG. 7 illustrates an example control circuit design 700 for a leakage insensitive transistor 701 in accordance with embodiments of the present disclosure. In the example shown, the transistor 701 is implemented the same or similar manner to the transistor 100 described above. That is, the transistor 701 includes a pt gate electrode 702 and nt gate electrode 704 on a gate dielectric 706, with a nb body electrode 710 and pb body electrode 712 on the substrate body 708. The materials used in each portion of the transistor 701 may be the same or similar to the materials used in the corresponding portion of the transistor 100 of FIGS. 1A-1B.

The circuit design 700 includes a set of traditional MOSFET transistors 714, 716, 718, 720 connected to the gate and body electrodes of the transistor 701. In particular, the gate and body electrodes of the transistor 701 are connected to the supply voltage (logic 1) and ground (logic 0) via the MOSFET transistors 714, 716, 718, 720, and their biasing is controlled by the switching of the MOSFET transistors, which is based on the "control" input signal shown. In the example shown, the pt gate electrode 702 is connected to the supply voltage through the pMOS transistor 714, the nt gate electrode 704 is connected to ground through the nMOS transistor 716, the nb body electrode 710 is connected to the supply voltage through the nMOS transistor 718, and the pb body electrode 712 is connected to ground through the pMOS transistor 720. The inputs to the pt, nb, pb, and nt electrodes are shown in FIG. 7 as "a", "b", "c", and "d", respectively and represented herein as {pt, nb, pb, nt} or {a, b, c, d}. There are two valid input combinations for the gate and body electrodes of the example transistor 701 of FIG. 7, and these are shown in Table 1 below.

**Table 1: Control signal to gate/body electrode inputs for control circuit shown in FIG. 7**

| **Control** | **{a, b, c, d}** |
|---|---|
| 0 | {1, x, 0, x} |
| 1 | {x, 1, x, 0} |

As seen in Table 1, the control circuit design 700 may convert a classical/binary/1-input logic signal of 0 or 1 into a 4-input logic signal for a six-electrode transistor design as described herein. Accordingly, in certain embodiments, the MOSFET portion of the example circuit design 700 shown in FIG. 7 may be implemented in certain embodiments to convert a classical/binary logic signal into one that can be utilized by a six-electrode transistor design as described herein. For instance, a set of four MOSFETs biased as shown in FIG. 7 may be used to convert the traditional 0,1 logic signal into a set of 4-input logic signals that can be input to a logic circuit that implements logic gates implemented six-electrode transistors such as transistor 701, e.g., as shown in FIG. 11.

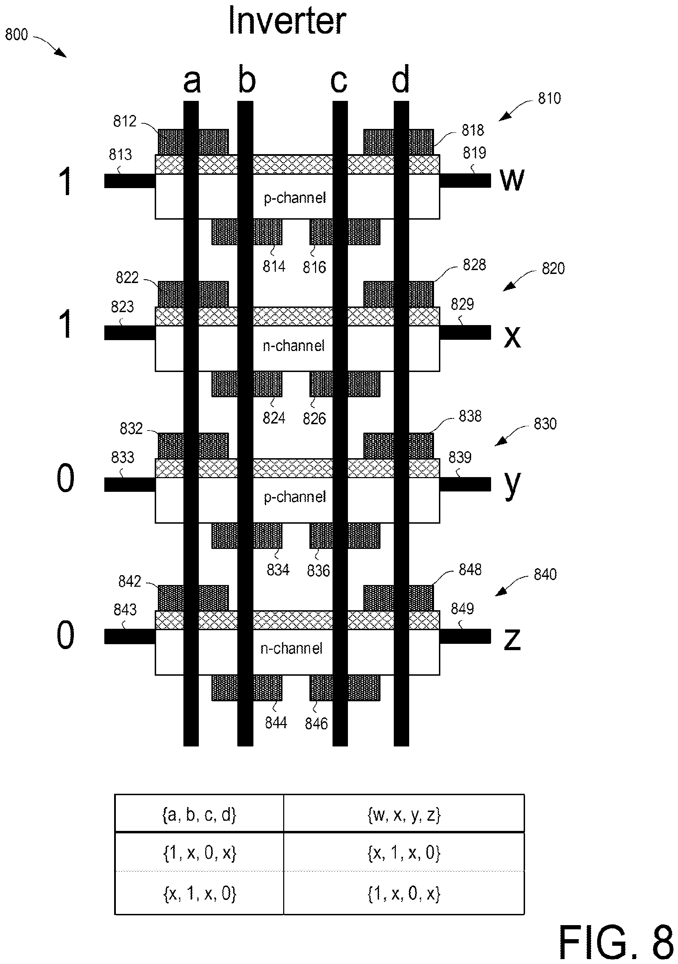

FIG. 8 illustrates an example inverter circuit 800 implemented by six-electrode transistors 810, 820, 830, 840 in accordance with embodiments of the present disclosure. In the example shown, the transistors 810, 820, 830, 840 are implemented in the same manner as the example transistor 100 of FIGS. 1A-1B. As shown in FIG. 8, the transistors 810, 830 are p-channel transistors similar to the transistors 400, 500 of FIGS. 4,5, while the transistors 820, 840 are n-channel transistors similar to the transistors 200, 300 of FIGS. 2, 3. The signal line labeled as "a" is connected to the electrodes 812, 822, 832, 842, the signal line labeled as "b" is connected to the electrodes 814, 824, 834, 844, the signal line labeled as "c" is connected to the electrodes 816, 826, 836, 846, and the signal line labeled as "d" is connected to the electrodes 818, 828, 838, 848. The source/drain electrode 813 of the transistor 810 and the source/drain electrode 823 of the transistor 820 are each held at logic 1, while the source/drain electrode 833 of the transistor 830 and the source/drain electrode 843 of the transistor 840 are held at logic 0. The source/drain electrode 819 of the transistor 810 provides an output signal line "w", the source/drain electrode 829 of the transistor 820 provides an output signal line "x", source/drain electrode 839 of the transistor 830 provides an output signal line "y", and source/drain electrode 849 of the transistor 840 provides an output signal line "z". The signal lines {a, b, c, d} may represent an input to the inverter circuit 800, while the signal lines {w, x, y, z} may represent an output of the inverter circuit 800. Table 2 below describes the truth table for the inverter circuit 800.

**Table 2: Truth table for inverter circuit shown in FIG. 8**

| **{a, b, c, d}** | **{w, x, y, z}** |
|---|---|
| {1, x, 0, x} | {x, 1, x, 0} |
| {x, 1, x, 0} | {1, x, 0, x} |

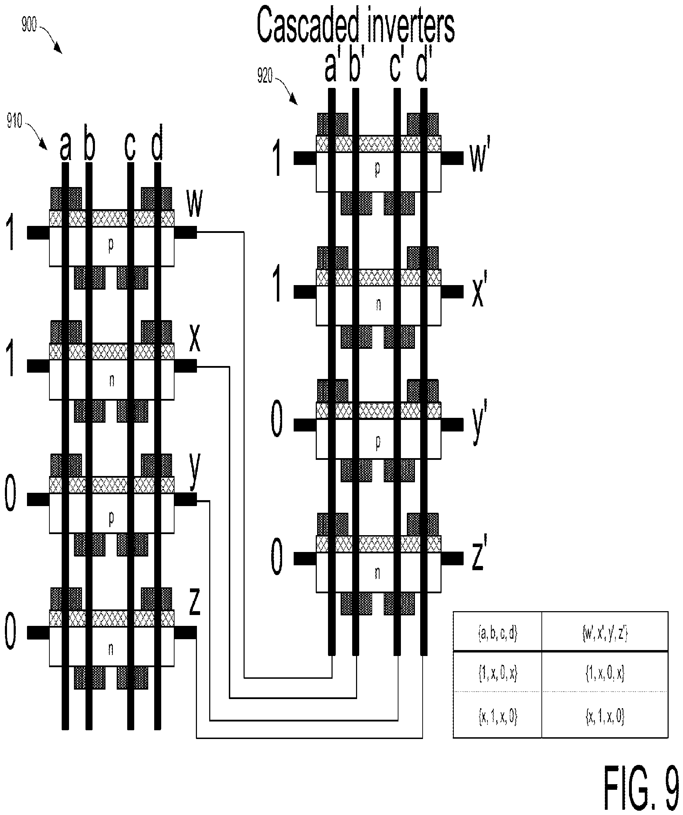

FIG. 9 illustrates an example two-cascaded inverter circuit 900 implemented by six-electrode transistors in accordance with embodiments of the present disclosure. The example two-cascaded inverter circuit 900 includes two inverter circuits 910, 920 that are each implemented in the same manner as the inverter circuit 900 of FIG. 9. In the example shown, the outputs {w, x, y, z} of the inverter circuit 910 are provided as inputs {a', b', c', d'} to the inverter circuit 920, which provides outputs {w', x', y', z'}. Table 2 below describes the truth table for the two-cascaded inverter circuit 900.

**Table 3: Truth table for two-cascaded inverter circuit shown in FIG. 9**

| **{a, b, c, d}** | **{w', x', y', z'}** |
|---|---|
| {1, x, 0, x} | {1, x, 0, x} |
| {x, 1, x, 0} | {x, 1, x, 0} |

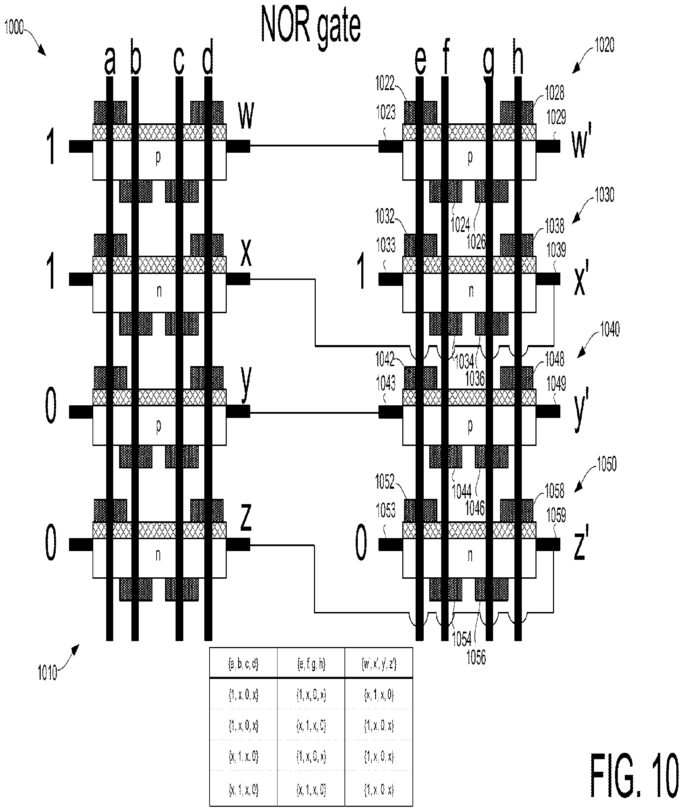

FIG. 10 illustrates an example NOR logic gate 1000 implemented by six-electrode transistors in accordance with embodiments of the present disclosure. The example NOR logic gate 1000 includes an inverter circuit 1010 that is implemented in the same manner as the inverter circuit 900 of FIG. 9. The transistors 1020, 1040 are p-channel transistors similar to the transistors 400, 500 of FIGS. 4,5, while the transistors 1030, 1050 are n-channel transistors similar to the transistors 200, 300 of FIGS. 2, 3. The signal lines {a, b, c, d} may represent an input to the inverter circuit 1010, while the signal lines {w, x, y, z} may represent an output of the inverter circuit 1010. The outputs {w, x, y, z} of the inverter circuit 1010 are connected to electrodes of the transistors 1020, 1030, 1040, 1050 as described below.

The signal line labeled as "e" is connected to the electrodes 1022, 1032, 1042, 1052, the signal line labeled as "fʺ is connected to the electrodes 1024, 1034, 1044, 1054, the signal line labeled as "g" is connected to the electrodes 1026, 1036, 1046, 1056, and the signal line labeled as "h" is connected to the electrodes 1028, 1038, 1048, 1058. The source/drain electrode 1023 of the transistor 1020 is connected to the output signal line "w" of the inverter circuit 1010, the source/drain electrode 1033 of the transistor 1030 is held at logic 1, the source/drain electrode 1043 of the transistor 1040 is connected to the output signal line "y" of the inverter circuit 1010, and the source/drain electrode 1053 of the transistor 1050 is held at logic 0. The output signal line "x" of the inverter circuit 1010 is connected to the source/drain electrode 1039 of the transistor 1030 and the output signal line "z" of the inverter circuit 1010 is connected to the source/drain electrode 1059 of the transistor 1050. The source/drain electrode 1029 of the transistor 1020 provides an output signal line "w"', the source/drain electrode 1039 of the transistor 1030 provides an output signal line "x"', source/drain electrode 1049 of the transistor 1040 provides an output signal line "y"', and source/drain electrode 1059 of the transistor 1050 provides an output signal line ʺz‴. Table 4 below describes the truth table for the NOR logic gate 1000.

**Table 4: Truth table for NOR logic gate shown in FIG. 10**

| **{a, b, c, d}** | **{e, f, g, h}** | **{w, x, y, z}** |
|---|---|---|
| {1, x, 0, x} | {1, x, 0, x} | {x, 1, x, 0} |
| {1, x, 0, x} | {x, 1, x, 0} | {1, x, 0, x} |
| {x, 1, x, 0} | {1, x, 0, x} | {1, x, 0, x} |
| {x, 1, x, 0} | {x, 1, x, 0} | {1, x, 0, x} |

FIG. 11 illustrates an example NAND logic gate 1100 implemented by six-electrode transistors in accordance with embodiments of the present disclosure. The example NAND logic gate 1100 includes an inverter circuit 1110 that is implemented in the same manner as the inverter circuit 800 of FIG. 8. The transistors 1120, 1140 are p-channel transistors similar to the transistors 400, 500 of FIGS. 4,5, while the transistors 1130, 1150 are n-channel transistors similar to the transistors 200, 300 of FIGS. 2, 3. The signal lines {a, b, c, d} may represent an input to the inverter circuit 1110, while the signal lines {w, x, y, z} may represent an output of the inverter circuit 1110. The outputs {w, x, y, z} of the inverter circuit 1110 are connected to electrodes of the transistors 1120, 1130, 1140, 1150 as described below.

The signal line labeled as "e" is connected to the electrodes 1122, 1132, 1142, 1152, the signal line labeled as "f' is connected to the electrodes 1124, 1134, 1144, 1154, the signal line labeled as "g" is connected to the electrodes 1126, 1136, 1146, 1156, and the signal line labeled as "h" is connected to the electrodes 1128, 1138, 1148, 1158. The source/drain electrode 1123 of the transistor 1120 is held at logic 1, the source/drain electrode 1133 of the transistor 1130 is connected to the output signal line "x" of the inverter circuit 1110, the source/drain electrode 1143 of the transistor 1140 is held at logic 0, and the source/drain electrode 1153 of the transistor 1150 is connected to the output signal line "z" of the inverter circuit 1110. The output signal line "w" of the inverter circuit 1110 is connected to the source/drain electrode 1129 of the transistor 1120 and the output signal line "y" of the inverter circuit 1110 is connected to the source/drain electrode 1149 of the transistor 1140. The source/drain electrode 1129 of the transistor 1120 provides an output signal line "w"', the source/drain electrode 1139 of the transistor 1130 provides an output signal line "x"', source/drain electrode 1149 of the transistor 1140 provides an output signal line ʺy‴, and source/drain electrode 1159 of the transistor 1150 provides an output signal line "z"'. Table 5 below describes the truth table for the NAND logic gate 1100.

**Table 5: Truth table for NAND logic gate shown in FIG. 11**

| **{a, b, c, d}** | **{e, f, g, h}** | **{w, x, y, z}** |
|---|---|---|
| {1, x, 0, x} | {1, x, 0, x} | {x, 1, x, 0} |
| {1, x, 0, x} | {x, 1, x, 0} | {x, 1, x, 0} |
| {x, 1, x, 0} | {1, x, 0, x} | {x, 1, x, 0} |
| {x, 1, x, 0} | {x, 1, x, 0} | {1, x, 0, x} |

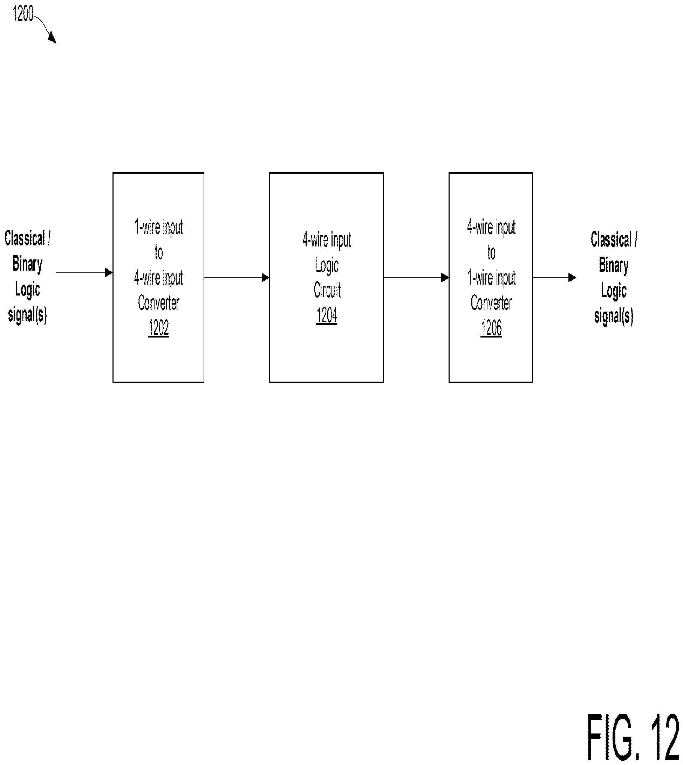

FIG. 12 illustrates an example hybrid logic circuit design 1200 that includes a 4-wire input logic circuit 1204 and converter circuits 1202, 1206 to convert classical/binary 1-wire input signals to 4-wire input signals (and vice versa) that may be utilized by the 4-wire input logic circuit 1204. The 1-wire input to 4-wire input converter circuit 1202 may take as input single bit logic signals (i.e., 0 or 1) and convert those signals into corresponding 4-wire signals that may be used as an inputs to a six-electrode transistor design as described herein (e.g., a transistor such as transistor 100 of FIGS. 1A-1B) that take 4 different input signals. In some instances, the circuit 1202 may be implemented in the same manner as, or similar to, the configuration of MOSFET transistors 714, 716, 718, 720 in the example circuit design 700 of FIG. 7.

The 4-wire input logic circuit 1204 may include a set of logic gates that are based on or include six-electrode transistor designs as described herein. For example, the logic circuit 1204 may include one or more of an inverter circuit such as inverter circuit 800 of FIG. 8, a two-cascaded inverter circuit such as two-cascaded inverter circuit 900 of FIG. 9, a NOR logic gate such as the NOR logic gate 1000 of FIG. 10, and a NAND logic gate such as the NAND logic gate 1100 of FIG. 11, or any combination thereof. The logic circuit 1204 may provide as output a 4-wire logic signal, which is provided to the 4-wire input to 1-wire input converter circuit 1206.

The circuit 1206 may convert the 4-wire signals output by the logic circuit 1204 and convert those signals into corresponding 1-wire/single bit logic signals (e.g., 0s or Is) that may be used in any suitable manner (e.g., as an output to be analyzed or as input to a classical logic circuit). The circuit 1206 may be implemented by a set of six-electrode transistors, such as those shown in FIG. 12.

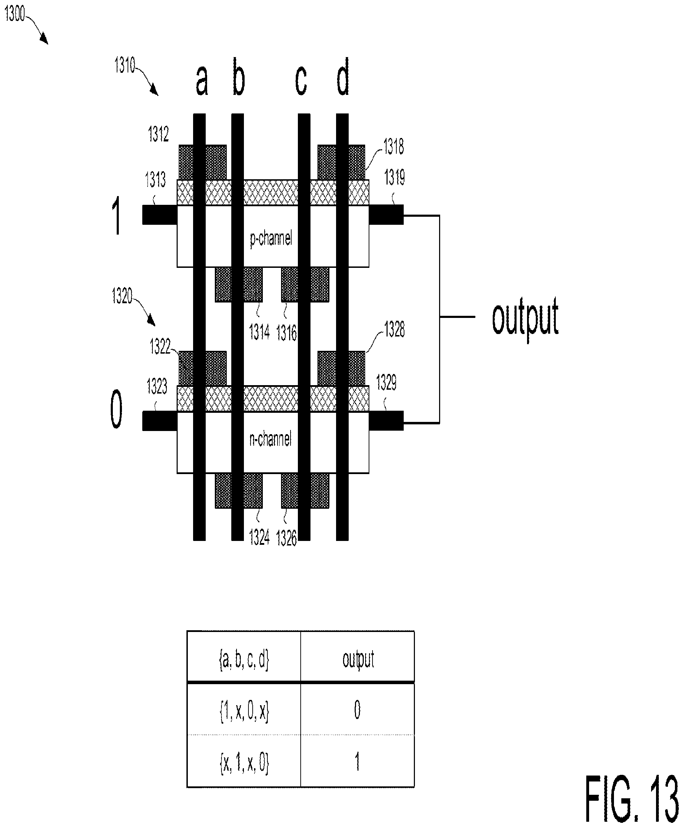

FIG. 13 illustrates an example 4-wire to 1-wire logic signal converter circuit 1300 in accordance with embodiments of the present disclosure. The example circuit 1300 includes transistors 1310, 1320, 1330, 1340 are implemented in the same manner as the example transistor 100 of FIGS. 1A-1B. As shown in FIG. 13, the transistor 1310 is a p-channel transistors similar to the transistors 400, 500 of FIGS. 4,5, while the transistor 1320 is a n-channel transistors similar to the transistors 200, 300 of FIGS. 2, 3. The signal line labeled as "a" is connected to the electrodes 1312, 1322, the signal line labeled as "b" is connected to the electrodes 1314, 1324, the signal line labeled as "c" is connected to the electrodes 1316, 1326, , and the signal line labeled as "d" is connected to the electrodes 1318, 1328.

The source/drain electrode 1313 of the transistor 1310 is held at logic 1, while the source/drain electrode 1323 of the transistor 1320 is held at logic 0. The source/drain electrode 1319 of the transistor 1310 is connected to the source/drain electrode 1329 of the transistor 1320, and they together provides an output signal line "output". Table 6 below describes the truth table for the converter circuit 1300.

**Table 6: Truth table for converter circuit shown in FIG. 13**

| **{a, b, c, d}** | **output** |
|---|---|
| {1, x, 0, x} | 0 |
| {x, 1, x, 0} | 1 |

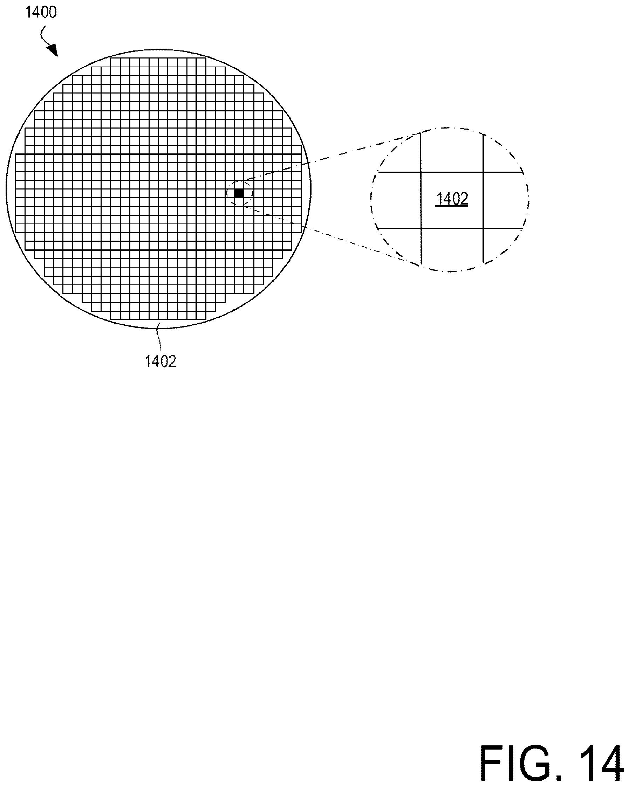

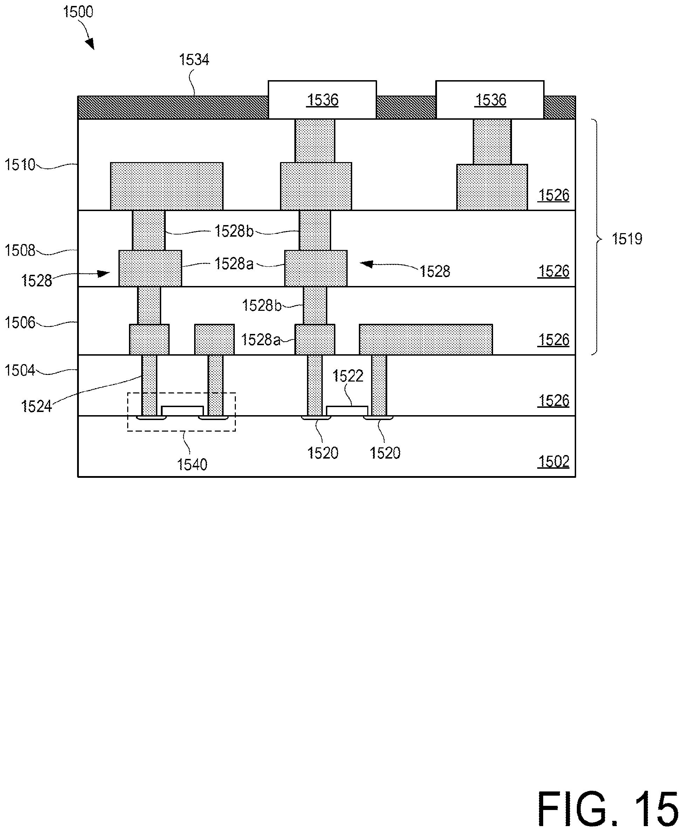

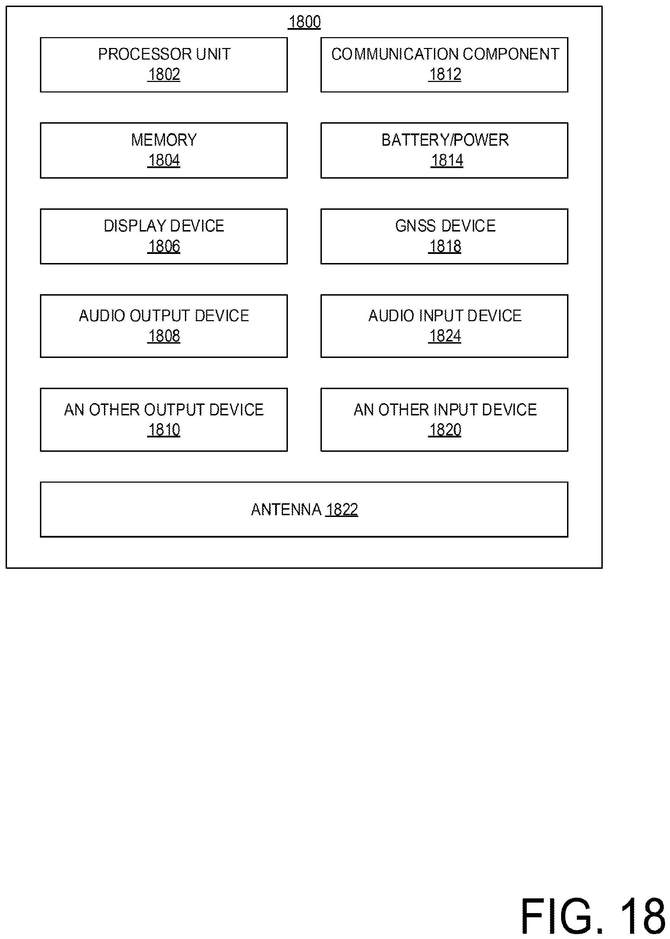

FIG. 14 is a top view of a wafer 1400 and dies 1402 that may include any of the six-electrode transistors disclosed herein. The wafer 1400 may be composed of semiconductor material and may include one or more dies 1402 having integrated circuit structures formed on a surface of the wafer 1400. The individual dies 1402 may be a repeating unit of an integrated circuit product that includes any suitable integrated circuit. After the fabrication of the semiconductor product is complete, the wafer 1400 may undergo a singulation process in which the dies 1402 are separated from one another to provide discrete "chips" of the integrated circuit product. The die 1402 may include any of the transistor designs disclosed herein. The die 1402 may include one or more transistors (e.g., some of the transistors 1540 of FIG. 15, discussed below or six-electrode transistors as described herein, or a combination thereof), supporting circuitry to route electrical signals to the transistors, passive components (e.g., signal traces, resistors, capacitors, or inductors), and/or any other integrated circuit components. In some embodiments, the wafer 1400 or the die 1402 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1402. For example, a memory array formed by multiple memory devices may be formed on a same die 1402 as a processor unit (e.g., the processor unit 1802 of FIG. 18) or other logic that is configured to store information in the memory devices or execute instructions stored in the memory array.

FIG. 15 is a cross-sectional side view of an integrated circuit device 1500 that may be included in any of the six-electrode transistors disclosed herein. One or more of the integrated circuit devices 1500 may be included in one or more dies 1402 (FIG. 14). The integrated circuit device 1500 may be formed on a die substrate 1502 (e.g., the wafer 1400 of FIG. 14) and may be included in a die (e.g., the die 1402 of FIG. 14). The die substrate 1502 may be a semiconductor substrate composed of semiconductor material systems including, for example, n-type or p-type materials systems (or a combination of both). The die substrate 1502 may include, for example, a crystalline substrate formed using a bulk silicon or a silicon-on-insulator (SOI) substructure. In some embodiments, the die substrate 1502 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 1502. Although a few examples of materials from which the die substrate 1502 may be formed are described here, any material that may serve as a foundation for an integrated circuit device 1500 may be used. The die substrate 1102 may be part of a singulated die (e.g., the dies 1402 of FIG. 14) or a wafer (e.g., the wafer 1400 of FIG. 14).

The integrated circuit device 1500 may include one or more device layers 1504 disposed on the die substrate 1502. The device layer 1504 may include features of one or more transistors 1540 (e.g., metal oxide semiconductor field-effect transistors (MOSFETs)) formed on the die substrate 1502. The transistors 1540 may include, for example, one or more source and/or drain (S/D) regions 1520, a gate 1522 to control current flow between the S/D regions 1520, and one or more S/D contacts 1524 to route electrical signals to/from the S/D regions 1520. The transistors 1540 may include additional features not depicted for the sake of clarity, such as device isolation regions, gate contacts, and the like. The transistors 1540 are not limited to the type and configuration depicted in FIG. 15 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon, nanosheet, or nanowire transistors.

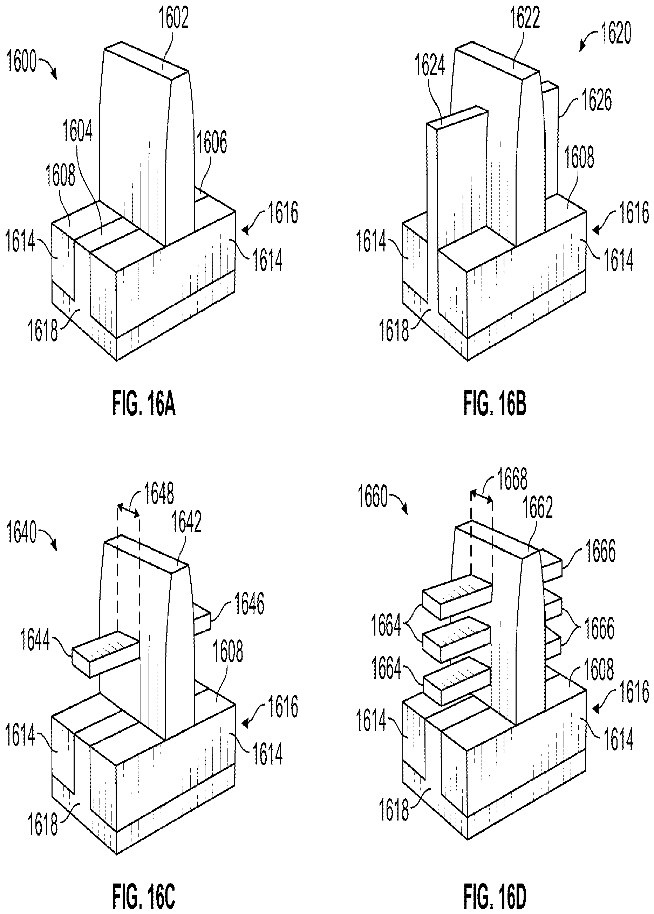

FIGS. 16A-16D are simplified perspective views of example planar, FinFET, gate-all-around, and stacked gate-all-around transistors. The transistors illustrated in FIGS. 16A-16D are formed on a substrate 1616 having a surface 1608. Isolation regions 1614 separate the source and drain regions of the transistors from other transistors and from a bulk region 1618 of the substrate 1616.

FIG. 16A is a perspective view of an example planar transistor 1600 comprising a gate 1602 that controls current flow between a source region 1604 and a drain region 1606. The transistor 1600 is planar in that the source region 1604 and the drain region 1606 are planar with respect to the substrate surface 1608.

FIG. 16B is a perspective view of an example FinFET transistor 1620 comprising a gate 1622 that controls current flow between a source region 1624 and a drain region 1626. The transistor 1620 is non-planar in that the source region 1624 and the drain region 1626 comprise "fins" that extend upwards from the substrate surface 1628. As the gate 1622 encompasses three sides of the semiconductor fin that extends from the source region 1624 to the drain region 1626, the transistor 1620 can be considered a tri-gate transistor. FIG. 16B illustrates one S/D fin extending through the gate 1622, but multiple S/D fins can extend through the gate of a FinFET transistor.

FIG. 16C is a perspective view of a gate-all-around (GAA) transistor 1640 comprising a gate 1642 that controls current flow between a source region 1644 and a drain region 1646. The transistor 1640 is non-planar in that the source region 1644 and the drain region 1646 are elevated from the substrate surface 1628.

FIG. 16D is a perspective view of a GAA transistor 1660 comprising a gate 1662 that controls current flow between multiple elevated source regions 1664 and multiple elevated drain regions 1666. The transistor 1660 is a stacked GAA transistor as the gate controls the flow of current between multiple elevated S/D regions stacked on top of each other. The transistors 1640 and 1660 are considered gate-all-around transistors as the gates encompass all sides of the semiconductor portions that extends from the source regions to the drain regions. The transistors 1640 and 1660 can alternatively be referred to as nanowire, nanosheet, or nanoribbon transistors depending on the width (e.g., widths 1648 and 1668 of transistors 1640 and 1660, respectively) of the semiconductor portions extending through the gate.

Returning to FIG. 15, a transistor 1540 may include a gate 1522 formed of at least two layers, a gate dielectric and a gate electrode. The gate dielectric may include one layer or a stack of layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1540 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1540 along the source-channel-drain direction, the gate electrode may consist of a U-shaped structure that includes a bottom portion substantially parallel to the surface of the die substrate 1502 and two sidewall portions that are substantially perpendicular to the top surface of the die substrate 1502. In other embodiments, at least one of the metal layers that form the gate electrode may simply be a planar layer that is substantially parallel to the top surface of the die substrate 1502 and does not include sidewall portions substantially perpendicular to the top surface of the die substrate 1502. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1520 may be formed within the die substrate 1502 adjacent to the gate 1522 of individual transistors 1540. The S/D regions 1520 may be formed using an implantation/diffusion process or an etching/deposition process, for example. In the former process, dopants such as boron, aluminum, antimony, phosphorous, or arsenic may be ion-implanted into the die substrate 1502 to form the S/D regions 1520. An annealing process that activates the dopants and causes them to diffuse farther into the die substrate 1502 may follow the ion-implantation process. In the latter process, the die substrate 1502 may first be etched to form recesses at the locations of the S/D regions 1520. An epitaxial deposition process may then be carried out to fill the recesses with material that is used to fabricate the S/D regions 1520. In some implementations, the S/D regions 1520 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1520 may be formed using one or more alternate semiconductor materials such as germanium or a group III-V material or alloy. In further embodiments, one or more layers of metal and/or metal alloys may be used to form the S/D regions 1520.

Electrical signals, such as power and/or input/output (I/O) signals, may be routed to and/or from the devices (e.g., transistors 1540) of the device layer 1504 through one or more interconnect layers disposed on the device layer 1504 (illustrated in FIG. 15 as interconnect layers 1506-1510). For example, electrically conductive features of the device layer 1504 (e.g., the gate 1522 and the S/D contacts 1524) may be electrically coupled with the interconnect structures 1528 of the interconnect layers 1506-1510. The one or more interconnect layers 1506-1510 may form a metallization stack (also referred to as an "ILD stack") 1519 of the integrated circuit device 1500.

The interconnect structures 1528 may be arranged within the interconnect layers 1506-1510 to route electrical signals according to a wide variety of designs; in particular, the arrangement is not limited to the particular configuration of interconnect structures 1528 depicted in FIG. 15. Although a particular number of interconnect layers 1506-1510 is depicted in FIG. 15, embodiments of the present disclosure include integrated circuit devices having more or fewer interconnect layers than depicted.

In some embodiments, the interconnect structures 1528 may include lines 1528a and/or vias 1528b filled with an electrically conductive material such as a metal. The lines 1528a may be arranged to route electrical signals in a direction of a plane that is substantially parallel with a surface of the die substrate 1502 upon which the device layer 1504 is formed. For example, the lines 1528a may route electrical signals in a direction in and out of the page and/or in a direction across the page from the perspective of FIG. 15. The vias 1528b may be arranged to route electrical signals in a direction of a plane that is substantially perpendicular to the surface of the die substrate 1502 upon which the device layer 1504 is formed. In some embodiments, the vias 1528b may electrically couple lines 1528a of different interconnect layers 1506-1510 together.

The interconnect layers 1506-1510 may include a dielectric material 1526 disposed between the interconnect structures 1528, as shown in FIG. 15. In some embodiments, dielectric material 1526 disposed between the interconnect structures 1528 in different ones of the interconnect layers 1506-1510 may have different compositions; in other embodiments, the composition of the dielectric material 1526 between different interconnect layers 1506-1510 may be the same. The device layer 1504 may include a dielectric material 1526 disposed between the transistors 1540 and a bottom layer of the metallization stack as well. The dielectric material 1526 included in the device layer 1504 may have a different composition than the dielectric material 1526 included in the interconnect layers 1506-1510; in other embodiments, the composition of the dielectric material 1526 in the device layer 1504 may be the same as a dielectric material 1526 included in any one of the interconnect layers 1506-1510.

A first interconnect layer 1506 (referred to as Metal 1 or "M1") may be formed directly on the device layer 1504. In some embodiments, the first interconnect layer 1506 may include lines 1528a and/or vias 1528b, as shown. The lines 1528a of the first interconnect layer 1506 may be coupled with contacts (e.g., the S/D contacts 1524) of the device layer 1504. The vias 1528b of the first interconnect layer 1506 may be coupled with the lines 1528a of a second interconnect layer 1508.

The second interconnect layer 1508 (referred to as Metal 2 or "M2") may be formed directly on the first interconnect layer 1506. In some embodiments, the second interconnect layer 1508 may include via 1528b to couple the lines 1528 of the second interconnect layer 1508 with the lines 1528a of a third interconnect layer 1510. Although the lines 1528a and the vias 1528b are structurally delineated with a line within individual interconnect layers for the sake of clarity, the lines 1528a and the vias 1528b may be structurally and/or materially contiguous (e.g., simultaneously filled during a dual-damascene process) in some embodiments.

The third interconnect layer 1510 (referred to as Metal 3 or "M3") (and additional interconnect layers, as desired) may be formed in succession on the second interconnect layer 1508 according to similar techniques and configurations described in connection with the second interconnect layer 1508 or the first interconnect layer 1506. In some embodiments, the interconnect layers that are "higher up" in the metallization stack 1519 in the integrated circuit device 1500 (i.e., farther away from the device layer 1504) may be thicker that the interconnect layers that are lower in the metallization stack 1519, with lines 1528a and vias 1528b in the higher interconnect layers being thicker than those in the lower interconnect layers.

The integrated circuit device 1500 may include a solder resist material 1534 (e.g., polyimide or similar material) and one or more conductive contacts 1536 formed on the interconnect layers 1506-1510. In FIG. 15, the conductive contacts 1536 are illustrated as taking the form of bond pads. The conductive contacts 1536 may be electrically coupled with the interconnect structures 1528 and configured to route the electrical signals of the transistor(s) 1540 to external devices. For example, solder bonds may be formed on the one or more conductive contacts 1536 to mechanically and/or electrically couple an integrated circuit die including the integrated circuit device 1500 with another component (e.g., a printed circuit board). The integrated circuit device 1500 may include additional or alternate structures to route the electrical signals from the interconnect layers 1506-1510; for example, the conductive contacts 1536 may include other analogous features (e.g., posts) that route the electrical signals to external components.

In some embodiments in which the integrated circuit device 1500 is a double-sided die, the integrated circuit device 1500 may include another metallization stack (not shown) on the opposite side of the device layer(s) 1504. This metallization stack may include multiple interconnect layers as discussed above with reference to the interconnect layers 1506-1510, to provide conductive pathways (e.g., including conductive lines and vias) between the device layer(s) 1504 and additional conductive contacts (not shown) on the opposite side of the integrated circuit device 1500 from the conductive contacts 1536.

In other embodiments in which the integrated circuit device 1500 is a double-sided die, the integrated circuit device 1500 may include one or more through silicon vias (TSVs) through the die substrate 1502; these TSVs may make contact with the device layer(s) 1504, and may provide conductive pathways between the device layer(s) 1504 and additional conductive contacts (not shown) on the opposite side of the integrated circuit device 1500 from the conductive contacts 1536. In some embodiments, TSVs extending through the substrate can be used for routing power and ground signals from conductive contacts on the opposite side of the integrated circuit device 1500 from the conductive contacts 1536 to the transistors 1540 and any other components integrated into the die 1500, and the metallization stack 1519 can be used to route I/O signals from the conductive contacts 1536 to transistors 1540 and any other components integrated into the die 1500.

Multiple integrated circuit devices 1500 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

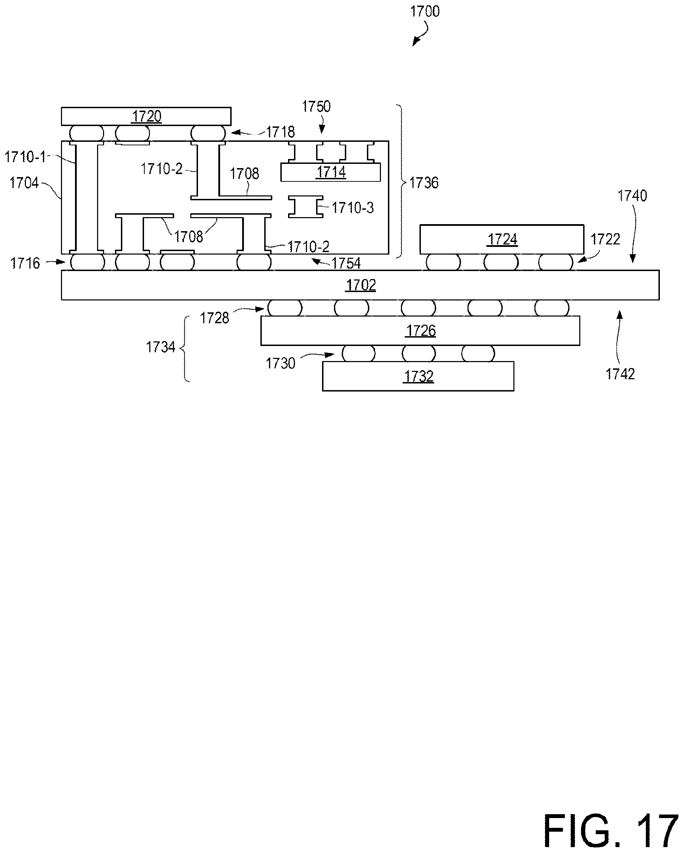

FIG. 17 is a cross-sectional side view of an integrated circuit device assembly 1700 that may include a microelectronic assembly, such as an integrated circuit device assembly including six-electrode transistors as described herein. The integrated circuit device assembly 1700 includes a number of components disposed on a circuit board 1702 (which may be a motherboard, system board, mainboard, etc.). The integrated circuit device assembly 1700 includes components disposed on a first face 1740 of the circuit board 1702 and an opposing second face 1742 of the circuit board 1702; generally, components may be disposed on one or both faces 1740 and 1742.

In some embodiments, the circuit board 1702 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate. The integrated circuit device assembly 1700 illustrated in FIG. 17 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 17), pins (e.g., as part of a pin grid array (PGA), contacts (e.g., as part of a land grid array (LGA)), male and female portions of a socket, an adhesive, an underfill material, and/or any other suitable electrical and/or mechanical coupling structure.

The package-on-interposer structure 1736 may include an integrated circuit component 1720 coupled to an interposer 1704 by coupling components 1718. The coupling components 1718 may take any suitable form for the application, such as the forms discussed above with reference to the coupling components 1716. Although a single integrated circuit component 1720 is shown in FIG. 17, multiple integrated circuit components may be coupled to the interposer 1704; indeed, additional interposers may be coupled to the interposer 1704. The interposer 1704 may provide an intervening substrate used to bridge the circuit board 1702 and the integrated circuit component 1720.

The integrated circuit component 1720 may be a packaged or unpacked integrated circuit product that includes one or more integrated circuit dies (e.g., the die 1002 of FIG. 10, the integrated circuit device 1500 of FIG. 15) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 1720, a single monolithic integrated circuit die comprises solder bumps attached to contacts on the die. The solder bumps allow the die to be directly attached to the interposer 1704. The integrated circuit component 1720 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 1720 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 1720 comprises multiple integrated circuit dies, they dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 1720 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 1704 may spread connections to a wider pitch or reroute a connection to a different connection. For example, the interposer 1704 may couple the integrated circuit component 1720 to a set of ball grid array (BGA) conductive contacts of the coupling components 1716 for coupling to the circuit board 1702. In the embodiment illustrated in FIG. 17, the integrated circuit component 1720 and the circuit board 1702 are attached to opposing sides of the interposer 1704; in other embodiments, the integrated circuit component 1720 and the circuit board 1702 may be attached to a same side of the interposer 1704. In some embodiments, three or more components may be interconnected by way of the interposer 1704.

In some embodiments, the interposer 1704 may be formed as a PCB, including multiple metal layers separated from one another by layers of dielectric material and interconnected by electrically conductive vias. In some embodiments, the interposer 1704 may be formed of an epoxy resin, a fiberglass-reinforced epoxy resin, an epoxy resin with inorganic fillers, a ceramic material, or a polymer material such as polyimide. In some embodiments, the interposer 1704 may be formed of alternate rigid or flexible materials that may include the same materials described above for use in a semiconductor substrate, such as silicon, germanium, and other group III-V and group IV materials. The interposer 1704 may include metal interconnects 1708 and vias 1710, including but not limited to through hole vias 1710-1 (that extend from a first face 1750 of the interposer 1704 to a second face 1754 of the interposer 1704), blind vias 1710-2 (that extend from the first or second faces 1750 or 1754 of the interposer 1704 to an internal metal layer), and buried vias 1710-3 (that connect internal metal layers).

In some embodiments, the interposer 1704 can comprise a silicon interposer. Through silicon vias (TSV) extending through the silicon interposer can connect connections on a first face of a silicon interposer to an opposing second face of the silicon interposer. In some embodiments, an interposer 1704 comprising a silicon interposer can further comprise one or more routing layers to route connections on a first face of the interposer 1704 to an opposing second face of the interposer 1704.

The interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1704. The package-on-interposer structure 1736 may take the form of any of the package-on-interposer structures known in the art. In embodiments where the interposer is a non-printed circuit board

The integrated circuit device assembly 1700 may include an integrated circuit component 1724 coupled to the first face 1740 of the circuit board 1702 by coupling components 1722. The coupling components 1722 may take the form of any of the embodiments discussed above with reference to the coupling components 1716, and the integrated circuit component 1724 may take the form of any of the embodiments discussed above with reference to the integrated circuit component 1720.

The integrated circuit device assembly 1700 illustrated in FIG. 17 includes a package-on-package structure 1734 coupled to the second face 1742 of the circuit board 1702 by coupling components 1728. The package-on-package structure 1734 may include an integrated circuit component 1726 and an integrated circuit component 1732 coupled together by coupling components 1730 such that the integrated circuit component 1726 is disposed between the circuit board 1702 and the integrated circuit component 1732. The coupling components 1728 and 1730 may take the form of any of the embodiments of the coupling components 1716 discussed above, and the integrated circuit components 1726 and 1732 may take the form of any of the embodiments of the integrated circuit component 1720 discussed above. The package-on-package structure 1734 may be configured in accordance with any of the package-on-package structures known in the art.

FIG. 18 is a block diagram of an example electrical device 1800 that may include one or more of the six-electrode transistor designs disclosed herein. For example, any suitable ones of the components of the electrical device 1800 may include one or more of the integrated circuit device assemblies 1700, integrated circuit components 1720, integrated circuit devices 1500, or integrated circuit dies 1402 disclosed herein, any of which may include six-electrode transistors as described herein. A number of components are illustrated in FIG. 18 as included in the electrical device 1800, but any one or more of these components may be omitted or duplicated, as suitable for the application. In some embodiments, some or all of the components included in the electrical device 1800 may be attached to one or more motherboards mainboards, or system boards. In some embodiments, one or more of these components are fabricated onto a single system-on-a-chip (SoC) die.

Additionally, in various embodiments, the electrical device 1800 may not include one or more of the components illustrated in FIG. 18, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include one or more processor units 1802 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 1802 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1800 may include a memory 1804, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1804 may include memory that is located on the same integrated circuit die as the processor unit 1802. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 1800 can comprise one or more processor units 1802 that are heterogeneous or asymmetric to another processor unit 1802 in the electrical device 1800. There can be a variety of differences between the processing units 1802 in a system in terms of a spectrum of metrics of merit including architectural, microarchitectural, thermal, power consumption characteristics, and the like. These differences can effectively manifest themselves as asymmetry and heterogeneity among the processor units 1802 in the electrical device 1800.

In some embodiments, the electrical device 1800 may include a communication component 1812 (e.g., one or more communication components). For example, the communication component 1812 can manage wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1812 may implement any of a number of wireless standards or protocols, including but not limited to Institute for Electrical and Electronic Engineers (IEEE) standards including Wi-Fi (IEEE 1302.11 family), IEEE 1302.16 standards (e.g., IEEE 1302.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 1302.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 1302.16 standards. The communication component 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication component 1812 may manage wired communications, such as electrical, optical, or any other suitable communication protocols (e.g., IEEE 1302.3 Ethernet standards). As noted above, the communication component 1812 may include multiple communication components. For instance, a first communication component 1812 may be dedicated to shorter-range wireless communications such as Wi-Fi or Bluetooth, and a second communication component 1812 may be dedicated to longer-range wireless communications such as global positioning system (GPS), EDGE, GPRS, CDMA, WiMAX, LTE, EV-DO, or others. In some embodiments, a first communication component 1812 may be dedicated to wireless communications, and a second communication component 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any embedded or wired or wirelessly connected external device that generates an audible indicator, such speakers, headsets, or earbuds.

The electrical device 1800 may include an audio input device 1824 (or corresponding interface circuitry, as discussed above). The audio input device 1824 may include any embedded or wired or wirelessly connected device that generates a signal representative of a sound, such as microphones, microphone arrays, or digital instruments (e.g., instruments having a musical instrument digital interface (MIDI) output). The electrical device 1800 may include a Global Navigation Satellite System (GNSS) device 1818 (or corresponding interface circuitry, as discussed above), such as a Global Positioning System (GPS) device. The GNSS device 1818 may be in communication with a satellite-based system and may determine a geolocation of the electrical device 1800 based on information received from one or more GNSS satellites, as known in the art.

The electrical device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include an other input device 1820 (or corresponding interface circuitry, as discussed above). Examples of the other input device 1820 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1800 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1800 may be any other electronic device that processes data. In some embodiments, the electrical device 1800 may comprise multiple discrete physical components. Given the range of devices that the electrical device 1800 can be manifested as in various embodiments, in some embodiments, the electrical device 1800 can be referred to as a computing device or a computing system.

Some examples of embodiments are provided below.

Example 1 includes an apparatus comprising: a substrate; a source region; a drain region; a channel region between the source region and drain region; a gate dielectric on the channel region; first and second electrodes on the gate dielectric; and third and fourth electrodes on the substrate.

Example 2 includes the subject matter of Example 1, wherein the source region, drain region, and channel region are proximate to a first side of the substrate, the gate dielectric is on the first side of the substrate, and the third electrode and fourth electrode are on a second side of the substrate opposite the first side.

Example 3 includes the subject matter of Example 2, wherein the source region is a first doped region in the substrate and the drain region is a second doped region in the substrate, and the apparatus further comprises a third doped region in the substrate and a fourth doped region in the substrate, wherein the third and fourth doped regions in the substrate are opposite polarity from the first and second doped regions, the third electrode is on the third doped region, and the fourth electrode is on the fourth doped region.

Example 4 includes the subject matter of Example 3, wherein the first electrode is nearer to the first doped region than the second doped region, the second electrode is nearer to the second doped region than the first doped region, the third doped region is nearer to the first doped region than the second doped region, and the fourth doped region is nearer to the second doped region than the first doped region.

Example 4.1 includes the subject matter of Example 3, wherein the first and second doped regions are n-type doped regions and the third and fourth doped regions are p-type doped regions.

Example 4.2 includes the subject matter of Example 4.1, wherein the substrate is p-type doped.

Example 4.3 includes the subject matter of Example 3, wherein the first and second doped regions are p-type doped regions and the third and fourth doped regions are n-type doped regions.

Example 4.4 includes the subject matter of Example 4.3, wherein the substrate is n-type doped.

Example 5 includes the subject matter of Example 1, wherein the source region, drain region, and channel region extend from a first side of the substrate, the gate dielectric is on an outer surface of the channel region extending from the first side of the substrate, and the third electrode and fourth electrode are on a second side of the substrate opposite the first side.

Example 6 includes the subject matter of any one of Examples 1-5, further comprising a fifth electrode on the source region and a sixth electrode on the drain region.

Example 7 includes a logic circuit comprising: a first field-effect transistor (FET) comprising first and second electrodes on a gate dielectric of the FET, third and fourth electrodes on the substrate of the FET, a fifth electrode on a source region of the FET, and a sixth electrode on a drain region of the FET; a second FET comprising first and second electrodes on a gate dielectric of the FET, third and fourth electrodes on the substrate of the FET, a fifth electrode on a source region of the FET, and a sixth electrode on a drain region of the FET; a third FET comprising first and second electrodes on a gate dielectric of the FET, third and fourth electrodes on the substrate of the FET, a fifth electrode on a source region of the FET, and a sixth electrode on a drain region of the FET; and a fourth FET comprising first and second electrodes on a gate dielectric of the FET, third and fourth electrodes on the substrate of the FET, a fifth electrode on a source region of the FET, and a sixth electrode on a drain region of the FET; wherein: the first electrode of the first FET, the first electrode of the second FET, the first electrode of the third FET, and the first electrode of the fourth FET are connected; the second electrode of the first FET, the second electrode of the second FET, the second electrode of the third FET, and the second electrode of the fourth FET are connected; the third electrode of the first FET, the third electrode of the second FET, the third electrode of the third FET, and the third electrode of the fourth FET are connected; and the fourth electrode of the first FET, the fourth electrode of the second FET, the fourth electrode of the third FET, and the fourth electrode of the fourth FET are connected.

Example 8 includes the subject matter of Example 7, wherein: the first FET is a p-channel FET and the fifth electrode of the first FET is connected to a supply voltage terminal; the second FET is a n-channel FET and the sixth electrode of the second FET is connected to a supply voltage terminal; the third FET is a p-channel FET and the sixth electrode of the third FET is connected to a ground terminal; and the fourth FET is a n-channel FET and the fifth electrode of the fourth FET is connected to a ground terminal.

Example 9 includes the subject matter of Example 7 or 8, further comprising: a fifth field-effect transistor (FET) comprising first and second electrodes on a gate dielectric of the FET, third and fourth electrodes on the substrate of the FET, a fifth electrode on a source region of the FET, and a sixth electrode on a drain region of the FET; a sixth FET comprising first and second electrodes on a gate dielectric of the FET, third and fourth electrodes on the substrate of the FET, a fifth electrode on a source region of the FET, and a sixth electrode on a drain region of the FET; a seventh FET comprising first and second electrodes on a gate dielectric of the FET, third and fourth electrodes on the substrate of the FET, a fifth electrode on a source region of the FET, and a sixth electrode on a drain region of the FET; and an eighth FET comprising first and second electrodes on a gate dielectric of the FET, third and fourth electrodes on the substrate of the FET, a fifth electrode on a source region of the FET, and a sixth electrode on a drain region of the FET; wherein: the first electrode of the fifth FET, the first electrode of the sixth FET, the first electrode of the seventh FET, and the first electrode of the eighth FET are connected; the second electrode of the fifth FET, the second electrode of the sixth FET, the second electrode of the seventh FET, and the second electrode of the eighth FET are connected; the third electrode of the fifth FET, the third electrode of the sixth FET, the third electrode of the seventh FET, and the third electrode of the eighth FET are connected; the fourth electrode of the fifth FET, the fourth electrode of the sixth FET, the fourth electrode of the seventh FET, and the fourth electrode of the eighth FET are connected; the sixth electrode of the first FET is connected to the fifth electrode of the fifth FET; the fifth electrode of the second FET is connected to the fifth electrode of the sixth FET; the fifth electrode of the third FET is connected to the sixth electrode of the seventh FET; and the sixth electrode of the fourth FET is connected to the sixth electrode of the eighth FET.

Example 10 includes the subject matter of Example 9, wherein: the fifth FET is a p-channel FET; the sixth FET is a n-channel FET and the sixth electrode of the sixth FET is connected to a supply voltage terminal; the seventh FET is a p-channel FET; and the eighth FET is a n-channel FET and the fifth electrode of the eighth FET is connected to a ground terminal.

Example 11 includes the subject matter of Example 7 or 8, further comprising: a fifth field-effect transistor (FET) comprising first and second electrodes on a gate dielectric of the FET, third and fourth electrodes on the substrate of the FET, a fifth electrode on a source region of the FET, and a sixth electrode on a drain region of the FET; a sixth FET comprising first and second electrodes on a gate dielectric of the FET, third and fourth electrodes on the substrate of the FET, a fifth electrode on a source region of the FET, and a sixth electrode on a drain region of the FET; a seventh FET comprising first and second electrodes on a gate dielectric of the FET, third and fourth electrodes on the substrate of the FET, a fifth electrode on a source region of the FET, and a sixth electrode on a drain region of the FET; and an eighth FET comprising first and second electrodes on a gate dielectric of the FET, third and fourth electrodes on the substrate of the FET, a fifth electrode on a source region of the FET, and a sixth electrode on a drain region of the FET; wherein: the first electrode of the fifth FET, the first electrode of the sixth FET, the first electrode of the seventh FET, and the first electrode of the eighth FET are connected; the second electrode of the fifth FET, the second electrode of the sixth FET, the second electrode of the seventh FET, and the second electrode of the eighth FET are connected; the third electrode of the fifth FET, the third electrode of the sixth FET, the third electrode of the seventh FET, and the third electrode of the eighth FET are connected; the fourth electrode of the fifth FET, the fourth electrode of the sixth FET, the fourth electrode of the seventh FET, and the fourth electrode of the eighth FET are connected; the sixth electrode of the first FET is connected to the sixth electrode of the fifth FET; the fifth electrode of the second FET is connected to the sixth electrode of the sixth FET; the fifth electrode of the third FET is connected to the fifth electrode of the seventh FET; and the sixth electrode of the fourth FET is connected to the fifth electrode of the eighth FET.

Example 11 includes the subject matter of Example 9, wherein: the fifth FET is a p-channel FET and the fifth electrode of the fifth FET is connected to a supply voltage terminal; the sixth FET is a n-channel FET; the seventh FET is a p-channel FET and the fifth electrode of the seventh FET is connected to a ground terminal; and the eighth FET is a n-channel FET.

Example 13 includes the subject matter of Examples 7-12, further comprising a 1-input to 4-input logic converter circuitry comprising: a input voltage terminal; a first p-channel metal-oxide semiconductor FET (MOSFET) comprising a source electrode connected to a supply voltage terminal, a gate electrode connected to the input voltage terminal, and a drain electrode coupled to the first electrodes of the first, second, third, and fourth FETs; a first n-channel MOSFET comprising a source electrode connected to a supply voltage terminal, a gate electrode connected to the input voltage terminal, and a drain electrode coupled to the third electrodes of the first, second, third, and fourth FETs; a second n-channel MOSFET comprising a source electrode connected to a ground terminal, a gate electrode connected to the input voltage terminal, and a drain electrode coupled to the second electrodes of the first, second, third, and fourth FETs; and a second p-channel MOSFET comprising a source electrode connected to a ground terminal, a gate electrode connected to the input voltage terminal, and a drain electrode coupled to the fourth electrodes of the first, second, third, and fourth FETs.

Example 14 includes the subject matter of Example 13, further comprising 4-input to 1-input logic converter circuitry comprising: a fifth field-effect transistor (FET) comprising first and second electrodes on a gate dielectric of the FET, third and fourth electrodes on the substrate of the FET, a fifth electrode on a source region of the FET, and a sixth electrode on a drain region of the FET; a sixth FET comprising first and second electrodes on a gate dielectric of the FET, third and fourth electrodes on the substrate of the FET, a fifth electrode on a source region of the FET, and a sixth electrode on a drain region of the FET; wherein: the first electrode of the fifth FET and the first electrode of the sixth FET are connected; the second electrode of the fifth FET and the second electrode of the sixth FET are connected; the third electrode of the fifth FET and the third electrode of the sixth FET are connected; the fourth electrode of the fifth FET and the fourth electrode of the sixth FET are connected; the fifth FET is a p-channel FET and the fifth electrode of the fifth FET is connected to a supply voltage terminal; and the sixth FET is a n-channel FET and the sixth electrode of the sixth FET is connected to a ground terminal.

Example 15 includes the subject matter of any one of Examples 7-14, wherein the first, second, third, and fourth FETs are planar FETs.

Example 16 includes the subject matter of any one of Examples 7-14, wherein the first, second, third, and fourth FETs are FinFETs.

Example 17 includes a method of operating a field effect transistor (FET) comprising: applying a first logic signal to a first electrode of the FET, the first electrode on a gate dielectric of the FET that is on a channel region of the FET between a source region and drain region of the FET; floating a second electrode of the FET, the second electrode on the gate dielectric; applying a second logic signal opposite the first logic signal to a third electrode of the FET, the third electrode on a substrate of the FET; and floating a fourth electrode of the FET, the fourth electrode on a substrate of the FET.

Example 18 includes the subject matter of Example 17, wherein the FET is a n-channel FET, the first logic signal is a logic 1, the second logic signal is a logic 0, and the FET is conducting current in the channel region.

Example 19 includes the subject matter of Example 17, wherein the FET is a n-channel FET, the first logic signal is a logic 0, the second logic signal is a logic 1, and the FET is not conducting current in the channel region.

Example 20 includes the subject matter of Example 17, wherein the FET is a p-channel FET, the first logic signal is a logic 1, the second logic signal is a logic 0, and the FET is not conducting current in the channel region.

Example 21 includes the subject matter of Example 17, wherein the FET is a p-channel FET, the first logic signal is a logic 0, the second logic signal is a logic 1, and the FET is conducting current in the channel region.

Example 22 includes the subject matter of any one of Examples 17-21, further comprising: applying the second logic signal to the second electrode of the FET; floating the first electrode of the FET; applying the first logic signal to the fourth electrode of the FET; and floating the third electrode of the FET.

Example 23 includes an apparatus of any one of Examples 1-6, further comprising means to implement the method of any one of Examples 17-22.

Example 24 includes a system comprising: a 1-input to 4-input logic converter circuit; a logic circuit to receive an output of the 1-input to 4-input logic converter circuit, the logic circuit comprising one or more six-electrode transistors; and a 4-input to 1-input logic converter circuit to receive an output of the logic circuit.

Example 25 includes the subject matter of Example 24, wherein the logic circuit comprises a plurality of logic gates comprising one or more of an inverter gate of Example 7 or 8, a NOR gate of Example 9 or 10, and a NAND gate of Example 11 or 12.

In the foregoing, a detailed description has been given with reference to specific example embodiments. It will, however, be evident that various modifications and changes may be made thereto without departing from the broader spirit and scope of the disclosure as set forth in the appended claims. The specification and drawings are, accordingly, to be regarded in an illustrative sense rather than a restrictive sense. Furthermore, the foregoing use of embodiment(s) and other exemplarily language does not necessarily refer to the same embodiment or the same example, but may refer to different and distinct embodiments, as well as potentially the same embodiment.

## Claims

1. An apparatus comprising:
a substrate;
a source region;
a drain region;
a channel region between the source region and drain region;
a gate dielectric on the channel region;
first and second electrodes on the gate dielectric; and
third and fourth electrodes on the substrate.

2. The apparatus of claim 1, wherein the source region, drain region, and channel region are proximate to a first side of the substrate, the gate dielectric is on the first side of the substrate, and the third electrode and fourth electrode are on a second side of the substrate opposite the first side.

3. The apparatus of claim 2, wherein the source region is a first doped region in the substrate and the drain region is a second doped region in the substrate, and the apparatus further comprises a third doped region in the substrate and a fourth doped region in the substrate, wherein the third and fourth doped regions in the substrate are opposite polarity from the first and second doped regions, the third electrode is on the third doped region, and the fourth electrode is on the fourth doped region.

4. The apparatus of claim 3, wherein the first electrode is nearer to the first doped region than the second doped region, the second electrode is nearer to the second doped region than the first doped region, the third doped region is nearer to the first doped region than the second doped region, and the fourth doped region is nearer to the second doped region than the first doped region.

5. The apparatus of claim 1, wherein the source region, drain region, and channel region extend from a first side of the substrate, the gate dielectric is on an outer surface of the channel region extending from the first side of the substrate, and the third electrode and fourth electrode are on a second side of the substrate opposite the first side.

6. A logic circuit comprising:
a first field-effect transistor (FET) comprising first and second electrodes on a gate dielectric of the FET, third and fourth electrodes on the substrate of the FET, a fifth electrode on a source region of the FET, and a sixth electrode on a drain region of the FET;
a second FET comprising first and second electrodes on a gate dielectric of the FET, third and fourth electrodes on the substrate of the FET, a fifth electrode on a source region of the FET, and a sixth electrode on a drain region of the FET;
a third FET comprising first and second electrodes on a gate dielectric of the FET, third and fourth electrodes on the substrate of the FET, a fifth electrode on a source region of the FET, and a sixth electrode on a drain region of the FET; and
a fourth FET comprising first and second electrodes on a gate dielectric of the FET, third and fourth electrodes on the substrate of the FET, a fifth electrode on a source region of the FET, and a sixth electrode on a drain region of the FET;
wherein:
the first electrode of the first FET, the first electrode of the second FET, the first electrode of the third FET, and the first electrode of the fourth FET are connected;
the second electrode of the first FET, the second electrode of the second FET, the second electrode of the third FET, and the second electrode of the fourth FET are connected;
the third electrode of the first FET, the third electrode of the second FET, the third electrode of the third FET, and the third electrode of the fourth FET are connected; and
the fourth electrode of the first FET, the fourth electrode of the second FET, the fourth electrode of the third FET, and the fourth electrode of the fourth FET are connected.

7. The logic circuit of claim 6, wherein:
the first FET is a p-channel FET and the fifth electrode of the first FET is connected to a supply voltage terminal;
the second FET is a n-channel FET and the sixth electrode of the second FET is connected to a supply voltage terminal;
the third FET is a p-channel FET and the sixth electrode of the third FET is connected to a ground terminal; and
the fourth FET is a n-channel FET and the fifth electrode of the fourth FET is connected to a ground terminal.

8. The logic circuit of claim 6 or 7, further comprising:
a fifth field-effect transistor (FET) comprising first and second electrodes on a gate dielectric of the FET, third and fourth electrodes on the substrate of the FET, a fifth electrode on a source region of the FET, and a sixth electrode on a drain region of the FET;
a sixth FET comprising first and second electrodes on a gate dielectric of the FET, third and fourth electrodes on the substrate of the FET, a fifth electrode on a source region of the FET, and a sixth electrode on a drain region of the FET;
a seventh FET comprising first and second electrodes on a gate dielectric of the FET, third and fourth electrodes on the substrate of the FET, a fifth electrode on a source region of the FET, and a sixth electrode on a drain region of the FET; and
an eighth FET comprising first and second electrodes on a gate dielectric of the FET, third and fourth electrodes on the substrate of the FET, a fifth electrode on a source region of the FET, and a sixth electrode on a drain region of the FET;
wherein:
the first electrode of the fifth FET, the first electrode of the sixth FET, the first electrode of the seventh FET, and the first electrode of the eighth FET are connected;
the second electrode of the fifth FET, the second electrode of the sixth FET, the second electrode of the seventh FET, and the second electrode of the eighth FET are connected;
the third electrode of the fifth FET, the third electrode of the sixth FET, the third electrode of the seventh FET, and the third electrode of the eighth FET are connected;
the fourth electrode of the fifth FET, the fourth electrode of the sixth FET, the fourth electrode of the seventh FET, and the fourth electrode of the eighth FET are connected;
the sixth electrode of the first FET is connected to the fifth electrode of the fifth FET;
the fifth electrode of the second FET is connected to the fifth electrode of the sixth FET;
the fifth electrode of the third FET is connected to the sixth electrode of the seventh FET; and
the sixth electrode of the fourth FET is connected to the sixth electrode of the eighth FET.

9. The logic circuit of claim 8, wherein:
the fifth FET is a p-channel FET;
the sixth FET is a n-channel FET and the sixth electrode of the sixth FET is connected to a supply voltage terminal;
the seventh FET is a p-channel FET; and
the eighth FET is a n-channel FET and the fifth electrode of the eighth FET is connected to a ground terminal.

10. The logic circuit of claim 6 or 7, further comprising:
a fifth field-effect transistor (FET) comprising first and second electrodes on a gate dielectric of the FET, third and fourth electrodes on the substrate of the FET, a fifth electrode on a source region of the FET, and a sixth electrode on a drain region of the FET;
a sixth FET comprising first and second electrodes on a gate dielectric of the FET, third and fourth electrodes on the substrate of the FET, a fifth electrode on a source region of the FET, and a sixth electrode on a drain region of the FET;
a seventh FET comprising first and second electrodes on a gate dielectric of the FET, third and fourth electrodes on the substrate of the FET, a fifth electrode on a source region of the FET, and a sixth electrode on a drain region of the FET; and
an eighth FET comprising first and second electrodes on a gate dielectric of the FET, third and fourth electrodes on the substrate of the FET, a fifth electrode on a source region of the FET, and a sixth electrode on a drain region of the FET;
wherein:
the first electrode of the fifth FET, the first electrode of the sixth FET, the first electrode of the seventh FET, and the first electrode of the eighth FET are connected;
the second electrode of the fifth FET, the second electrode of the sixth FET, the second electrode of the seventh FET, and the second electrode of the eighth FET are connected;
the third electrode of the fifth FET, the third electrode of the sixth FET, the third electrode of the seventh FET, and the third electrode of the eighth FET are connected;
the fourth electrode of the fifth FET, the fourth electrode of the sixth FET, the fourth electrode of the seventh FET, and the fourth electrode of the eighth FET are connected;
the sixth electrode of the first FET is connected to the sixth electrode of the fifth FET;
the fifth electrode of the second FET is connected to the sixth electrode of the sixth FET;
the fifth electrode of the third FET is connected to the fifth electrode of the seventh FET; and
the sixth electrode of the fourth FET is connected to the fifth electrode of the eighth FET.

11. The logic circuit of claim 10, wherein:
the fifth FET is a p-channel FET and the fifth electrode of the fifth FET is connected to a supply voltage terminal;
the sixth FET is a n-channel FET;
the seventh FET is a p-channel FET and the fifth electrode of the seventh FET is connected to a ground terminal; and
the eighth FET is a n-channel FET.

12. The logic circuit of any one of claims 6-11, further comprising 1-input to 4-input logic converter circuitry comprising:
a input voltage terminal;
a first p-channel metal-oxide semiconductor FET (MOSFET) comprising a source electrode connected to a supply voltage terminal, a gate electrode connected to the input voltage terminal, and a drain electrode coupled to the first electrodes of the first, second, third, and fourth FETs;
a first n-channel MOSFET comprising a source electrode connected to a supply voltage terminal, a gate electrode connected to the input voltage terminal, and a drain electrode coupled to the third electrodes of the first, second, third, and fourth FETs;
a second n-channel MOSFET comprising a source electrode connected to a ground terminal, a gate electrode connected to the input voltage terminal, and a drain electrode coupled to the second electrodes of the first, second, third, and fourth FETs; and
a second p-channel MOSFET comprising a source electrode connected to a ground terminal, a gate electrode connected to the input voltage terminal, and a drain electrode coupled to the fourth electrodes of the first, second, third, and fourth FETs.

13. The logic circuit of claim 12, further comprising 4-input to 1-input logic converter circuitry comprising:
a fifth field-effect transistor (FET) comprising first and second electrodes on a gate dielectric of the FET, third and fourth electrodes on the substrate of the FET, a fifth electrode on a source region of the FET, and a sixth electrode on a drain region of the FET;
a sixth FET comprising first and second electrodes on a gate dielectric of the FET, third and fourth electrodes on the substrate of the FET, a fifth electrode on a source region of the FET, and a sixth electrode on a drain region of the FET;
wherein:
the first electrode of the fifth FET and the first electrode of the sixth FET are connected;
the second electrode of the fifth FET and the second electrode of the sixth FET are connected;
the third electrode of the fifth FET and the third electrode of the sixth FET are connected;
the fourth electrode of the fifth FET and the fourth electrode of the sixth FET are connected;
the fifth FET is a p-channel FET and the fifth electrode of the fifth FET is connected to a supply voltage terminal; and
the sixth FET is a n-channel FET and the sixth electrode of the sixth FET is connected to a ground terminal.

14. A method of operating a field effect transistor (FET) comprising:
applying a first logic signal to a first electrode of the FET, the first electrode on a gate dielectric of the FET that is on a channel region of the FET between a source region and drain region of the FET;
floating a second electrode of the FET, the second electrode on the gate dielectric;
applying a second logic signal opposite the first logic signal to a third electrode of the FET, the third electrode on a substrate of the FET; and
floating a fourth electrode of the FET, the fourth electrode on a substrate of the FET.

15. The method of claim 14, further comprising:
applying the second logic signal to the second electrode of the FET;
floating the first electrode of the FET;
applying the first logic signal to the fourth electrode of the FET; and floating the third electrode of the FET.
